# EUROPEAN PATENT APPLICATION

(11) **EP 2 448 033 A1**
(43) Date of publication of application: **02.05.2012**
(21) Application number: 10792110.8
(22) Date of filing: 16.06.2010
(51) Int. Cl.: H01L 51/50, C08G 61/12

(54) **ORGANIC ELECTROLUMINESCENT ELEMENT**

(30) Priority: 23.06.2009 JP 2009148556; 29.10.2009 JP 2009248791; 18.12.2009 JP 2009287739; 09.02.2010 JP 2010026305
(71) Applicant: Sumitomo Chemical Company, Limited, Tokyo 104-8260 (JP)
(72) Inventor: UETANI, Yasunori, Tsukuba-shi Ibaraki 305-0045 (JP); FUJIWARA, Jun, Ashiya-shi Hyogo 659-0055 (JP)
(74) Representative: Duckworth, Timothy John
(86) International application number: PCT/JP2010/060590
(87) International publication number: WO 2010/150792

(57) **Abstract**

An organic electroluminescent element comprising a pair of electrodes composed of an anode and a cathode, a light-emitting layer provided between the electrodes, and a functional layer provided between the light-emitting layer and the anode, wherein the functional layer comprises an n-type semiconductor and a macromolecular compound comprising a repeating unit having an amine residue.

## Description

### Technical Field

The present invention relates to an organic electroluminescent element (hereinafter may be referred to as an organic EL element).

### Background Art

Organic EL elements are broadly classified into high-molecular type organic EL elements that use high-molecular-weight organic light-emitting materials and low-molecular type organic EL elements that use low-molecular-weight organic light-emitting materials. The high-molecular type organic EL elements can be manufactured using an applying method and are expected to be manufactured using a relatively simple method than that used for the low-molecular type elements. Therefore, extensive research and development such as materials development is currently being conducted for the purpose of improving the characteristics of the elements.

For example, an organic EL element including a light-emitting layer comprising polyfluorene that is a conjugated macromolecular compound (Advanced Materials 2000, vol. 12, No. 23, p.1737-1750), an organic EL element including a hole transport layer comprising a macromolecular compound having an arylamine structure (WO 1999/054385 A1), and an organic EL element including a hole transport layer comprising a cross-linkable arylamine macromolecular compound (WO 2005/052027 A1) have been proposed.

### Disclosure of the Invention

However, the element life LT80 of the above conventional organic EL elements is not always satisfactory, wherein the LT80 is the time from the start of operation until brightness is reduced to 80 with the brightness at the start of the operation set to 100.

It is an object of the present invention to provide an organic EL element having a long element life LT80.

The present invention relates to the following organic electroluminescent elements, light-emitting device, and display device.
[1] An organic electroluminescent element comprising:
   a pair of electrodes composed of an anode and a cathode;
   a light-emitting layer provided between the electrodes; and
   a functional layer provided between the light-emitting layer and the anode, wherein
   the functional layer comprises an n-type semiconductor and a macromolecular compound comprising a repeating unit having an amine residue.
[2] The organic electroluminescent element according to [1], wherein the n-type semiconductor is a fullerene and/or a fullerene derivative.
[3] The organic electroluminescent element according to [1], wherein the n-type semiconductor is a tetracarboxylic diimide derivative of perylene or naphthalene, or a tetracarboxylic dianhydride derivative of perylene or naphthalene.
[4] The organic electroluminescent element according to any one of [1] to [3], wherein the n-type semiconductor is a macromolecular compound.
[5] The organic electroluminescent element according to any one of [1] to [4], wherein the functional layer is in contact with the light-emitting layer.
[6] The organic electroluminescent element according to any one of [1] to [5], wherein the repeating unit having an amine residue is represented by the following formula (1): 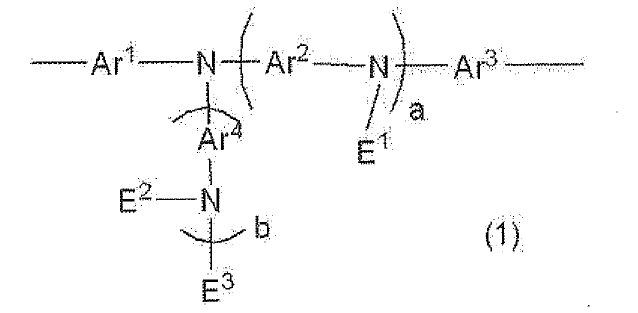 wherein
   Ar¹, Ar², Ar³ and Ar⁴ each independently represent an arylene group or a divalent heterocyclic group; E¹, E² and E³ each independently represent an aryl group or a monovalent heterocyclic group; and a and b each independently represent 0 or 1, and
   a group selected from among the groups represented by Ar¹, Ar³, Ar⁴, E¹ and E² may be bonded, directly or via -O-, -S-, -C(=O)-, -C(=O)-O-, -N(R⁷)-, -C(=O)-N(R⁷)-, or - C(R⁷) (R⁷)-, to a group selected from among the groups represented by Ar¹, Ar², Ar³, Ar⁴, E¹, E² and E³ which is bonded to the same nitrogen atom to which the former group selected is bonded, thereby forming a 5- to 7-membered ring,
   wherein R⁷ represents a hydrogen atom, an alkyl group, an aryl group, or a monovalent aromatic heterocyclic group; the group represented by R⁷ is optionally substituted with an alkyl group, an alkoxy group, an alkylthio group, a substituted carbonyl group, a substituted carboxyl group, an aryl group, an aryloxy group, an arylthio group, an aralkyl group, a monovalent aromatic heterocyclic group, a fluorine atom, or a cyano group; and a plurality of R⁷ may be the same as or different from each other.
[7] The organic electroluminescent element according to any one of [1] to [6], wherein the macromolecular compound further comprises, in addition to the repeating unit represented by the formula (1), one or more types of repeating units selected from the group consisting of repeating units represented by the following formula (2), (3), (4) or (5):

   -Ar¹²- (2)

   -Ar¹²-X¹-(Ar¹³-X²)_{c}-Ar¹⁴- (3)

   -Ar¹²-X²- (4)

   -X²- (5)

   wherein Ar¹², Ar¹³ and Ar¹⁴ each independently represent an arylene group, a divalent heterocyclic group, or a divalent group having a metal complex structure; X¹ represents - CR²=CR³-, -C≡C-, or -(SiR⁵R⁶)_{d}-; X² represents -CR²=CR³-, - C≡C-, -N(R⁴)-, or -(SiR⁵R⁶)_{d}-; R² and R³ each independently represent a hydrogen atom, an alkyl group, an aryl group, a monovalent heterocyclic group, a carboxyl group, a substituted carboxyl group, or a cyano group; R⁴, R⁵ and R⁶ each independently represent a hydrogen atom, an alkyl group, an aryl group, a monovalent heterocyclic group, or an arylalkyl group; c represents an integer from 0 to 2; d represents an integer from 1 to 12; and when Ar¹³, R², R³, R⁵ and R⁶ are each plurally present, they may be the same as or different from each other.
[8] The organic electroluminescent element according to any one of [1] to [7], wherein the macromolecular compound is a macromolecular compound in which a compound comprising at least one polymerizable substituent in the molecule thereof is polymerized.
   More specifically, the compound comprising at least one polymerizable substituent in the molecule thereof is a macromolecular compound comprising a repeating unit that has an amine residue and comprises a polymerizable substituent.
[9] The organic electroluminescent element according to any one of [2] to [8], wherein the fullerene derivative is a macromolecular compound in which a compound comprising at least one polymerizable substituent in the molecule thereof is polymerized.
   More specifically, the compound comprising at least one polymerizable substituent in the molecule thereof is a fullerene derivative comprising a polymerizable substituent.
[10] A light-emitting device comprising the organic electroluminescent element of any one of [1] to [9].
[11] A display device comprising the organic electroluminescent element of any one of [1] to [9].

### Embodiments for Carrying Out the Invention

The present invention will next be described in detail.

The organic EL element of the present invention is an organic EL element comprising a pair of electrodes composed of an anode and a cathode, a light-emitting layer provided between the electrodes, and a functional layer provided between the light-emitting layer and the anode, wherein the functional layer comprises an n-type semiconductor and a macromolecular compound comprising a repeating unit having an amine residue. The macromolecular compound generally has a number average molecular weight of 10³ to 10⁸ in terms of polystyrene. By providing, between the anode and the light-emitting layer, the functional layer that comprises a macromolecular compound comprising an n-type semiconductor and a repeating unit having an amine residue, an organic EL element having a long element life LT80 can be achieved.

In the present specification, the amine residue means a divalent group formed of an atomic group obtained by removing one hydrogen atom from each of two substituents bonded to the nitrogen atom in an amine compound.

The repeating unit having an amine residue preferably has a substituent such as an arylene group, a heterocyclic group, or an aryl group, and preferably has an arylamine residue (an amine residue derived from an arylamine compound).

Preferably, the repeating unit having an amine residue is a repeating unit represented by the following formula (1): 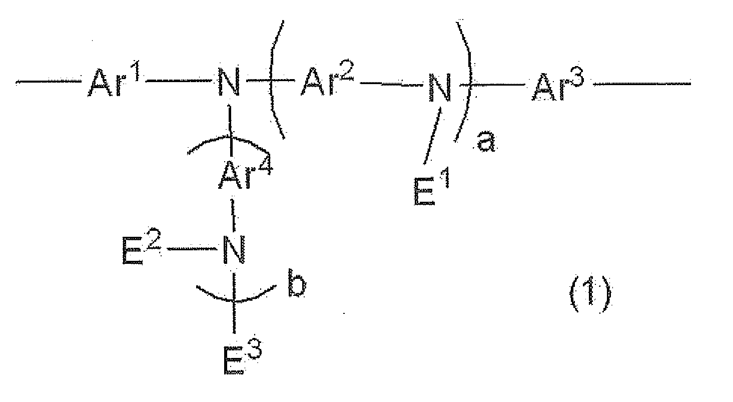 wherein Ar¹, Ar², Ar³ and Ar⁴ each independently represent an arylene group or a divalent heterocyclic group; E¹, E² and E³ each independently represent an aryl group or a monovalent heterocyclic group; and a and b each independently represent 0 or 1.

A group selected from among the groups represented by Ar¹, Ar³, Ar⁴, E¹ and E² (preferably a group selected from among the groups represented by Ar⁴, E¹ and E²) may be bonded, directly or via -O-, -S-, -C(=O)-, -C(=O)-O-, - N(R⁷)-, -C(=O)-N(R⁷)-, or -C(R⁷)(R⁷)-, to a group selected from among the groups represented by Ar¹, Ar², Ar³, Ar⁴, E¹, E² and E³ which is bonded to the same nitrogen atom to which the former group selected is bonded, thereby forming a 5- to 7-membered ring.

Examples of a group which is bonded to the same nitrogen atom to which Ar¹ is bonded may include Ar² (when a = 1), Ar³ (when a = 0), Ar⁴ (when b = 1), and E³ (when b = 0).

R⁷ represents a hydrogen atom, an alkyl group, an aryl group, or a monovalent aromatic heterocyclic group. The group represented by R⁷ is optionally substituted with an alkyl group, an alkoxy group, an alkylthio group, a substituted carbonyl group, a substituted carboxyl group, an aryl group, an aryloxy group, an arylthio group, an aralkyl group, a monovalent aromatic heterocyclic group, a fluorine atom, or a cyano group. A plurality of R⁷ may be the same as or different from each other.

Preferably, a and b satisfy 0 ≤ a + b ≤ 1 because the element life tends to be extended.

The arylene group is an atomic group obtained by removing two hydrogen atoms from an aromatic hydrocarbon, and includes a group having a benzene ring or a condensed ring; and a group in which two or more independent benzene rings or condensed rings are bonded directly or via a group such as vinylene. The arylene group may have a substituent. The substituent may include an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, a substituted amino group, a silyl group, a substituted silyl group, a silyloxy group, a substituted silyloxy group, a halogen atom, an acyl group, an acyloxy group, an imine residue, an amido group, an acid imido group, a monovalent heterocyclic group, a carboxyl group, a substituted carboxyl group, a cyano group, a polymerizable substituent, and the like. Of these, an alkyl group, an alkoxy group, an alkylthio group, an aryl group, an aryloxy group, an arylthio group, a substituted amino group, a substituted silyl group, a substituted silyloxy group, and a monovalent heterocyclic group are preferred.

The number of carbon atoms in the arylene group except for those in the substituent is generally about 6 to 60, and preferably 6 to 20. The total number of carbon atoms of the arylene group, including those of the substituent, is generally about 6 to 100.

The arylene group may include a phenylene group (for example, formulae 1 to 3 in the following diagrams), a naphthalene-diyl group (formulae 4 to 13 in the following diagrams), an anthracene-diyl group (formulae 14 to 19 in the following diagrams), a biphenyl-diyl group (formulae 20 to 25 in the following diagrams), a terphenyl-diyl group (formulae 26 to 28 in the following diagrams), a condensed ring compound group (formulae 29 to 35 in the following diagrams), a fluorene-diyl group (formulae 36 to 38 in the following diagrams), an indenofluorene-diyl group (38A and 38B in the following diagrams), an indenonaphthalene-diyl group (38C to 38E in the following diagrams), a stilbene-diyl group (formulae A to D in the following diagrams), a distilbene-diyl group (formulae E and F in the following diagrams), and the like. Of these, a phenylene group, a biphenyl-diyl group, a fluorene-diyl group, an indenonaphthalene-diyl group, and a stilbene-diyl group are preferred.

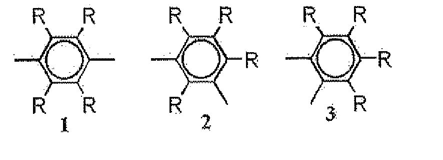

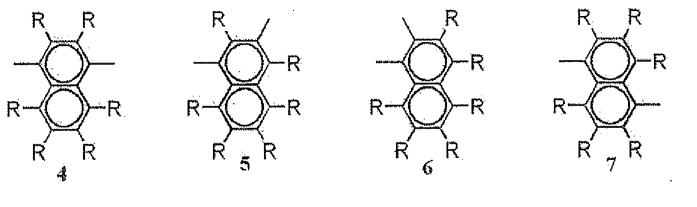

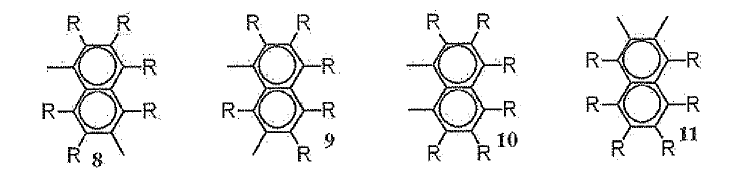

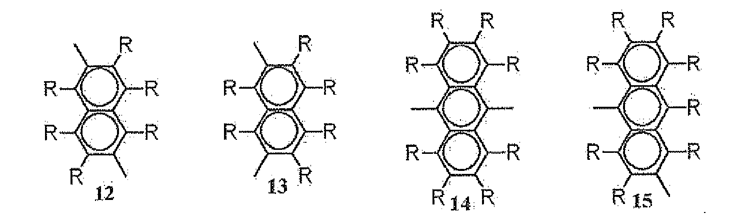

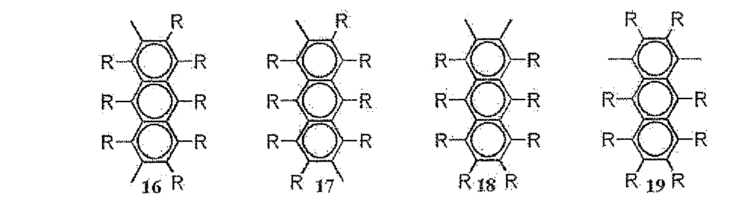

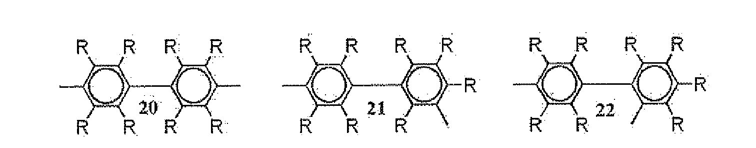

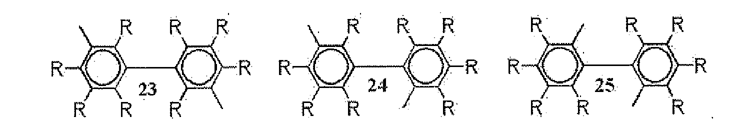

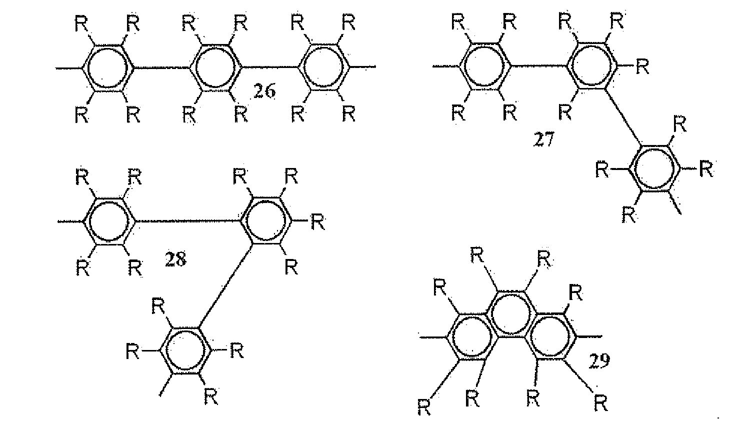

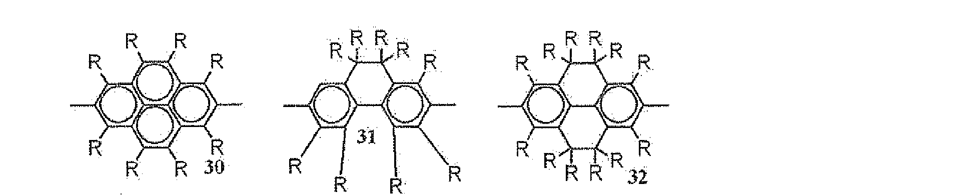

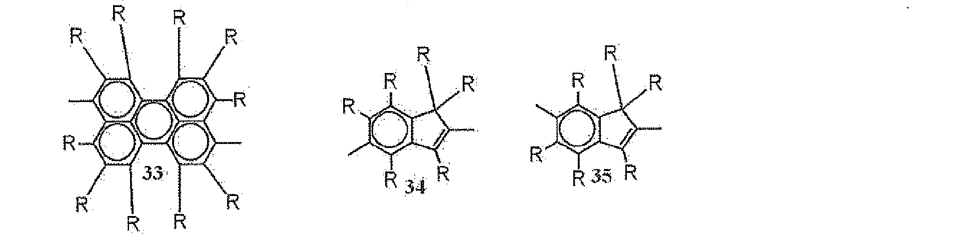

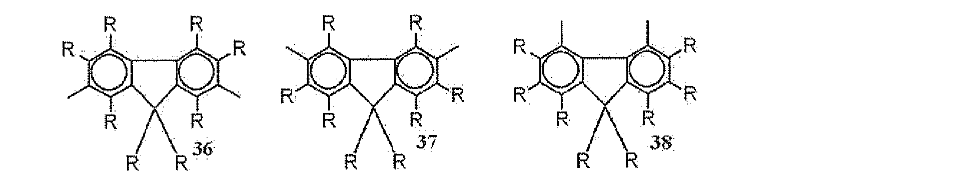

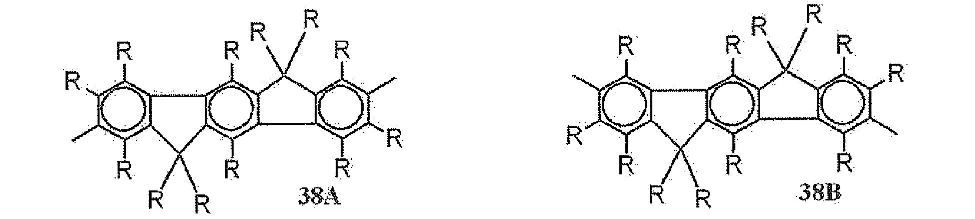

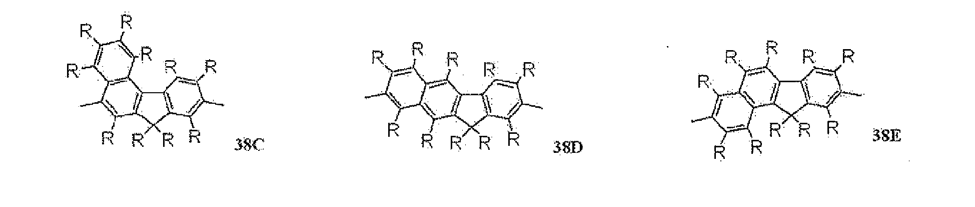

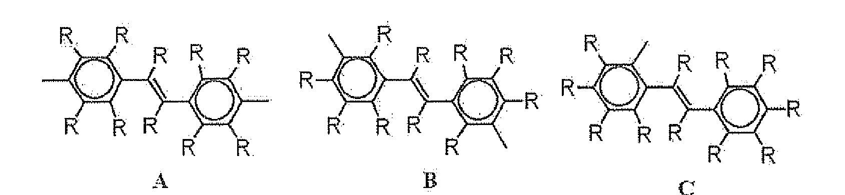

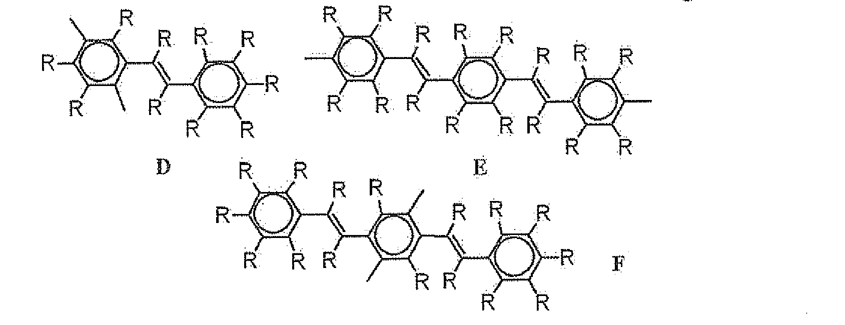

In the present invention, the divalent heterocyclic group means an atomic group remaining after removing two hydrogen atoms from a heterocyclic compound, and the divalent heterocyclic group may have a substituent. The heterocyclic compound is an organic compound having a ring structure, in which the elements constituting the ring are not only carbon atoms. The heterocyclic compound comprises, in addition to a carbon atom, a hetero atom such as an oxygen, sulfur, nitrogen, phosphorus, boron and arsenic atom in the ring thereof. The substituent may include an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, a substituted amino group, a silyl group, a substituted silyl group, a silyloxy group, a substituted silyloxy group, a halogen atom, an acyl group, an acyloxy group, an imine residue, an amido group, an acid imido group, a monovalent heterocyclic group, a carboxyl group, a substituted carboxyl group, a cyano group, a polymerizable substituent, and the like. Of these, an alkyl group, an alkoxy group, an alkylthio group, an aryl group, an aryloxy group, an arylthio group, a substituted amino group, a substituted silyl group, a substituted silyloxy group, and a monovalent heterocyclic group are preferred. The number of carbon atoms in the divalent heterocyclic group except for those in the substituent is generally about 3 to 60.

The total number of carbon atoms of the divalent heterocyclic group including those of the substituent is generally about 3 to 100. Of these divalent heterocyclic groups, a divalent aromatic heterocyclic group is preferred.

Examples of the divalent heterocyclic group may include the following:
a divalent heterocyclic group having nitrogen as a hetero atom, for example, a pyridine-diyl group (formulae 39 to 44 in the following diagrams), a diazaphenylene group (formulae 45 to 48 in the following diagrams), a quinolinediyl group (formulae 49 to 63 in the following diagrams), a quinoxalinediyl group (formulae 64 to 68 in the following diagrams), an acridinediyl group (formulae 69 to 72 in the following diagrams), a bipyridyldiyl group (formulae 73 to 75 in the following diagrams), and a phenanthrolinediyl group (formulae 76 to 78 in the following diagrams);
a group containing a hetero atom such as oxygen, silicon, nitrogen, sulfur, selenium and boron and having a fluorene structure (formulae 79 to 93 and G to I in the following diagrams);
a group containing a hetero atom such as oxygen, silicon, nitrogen, sulfur, selenium and boron and having an indenofluorene structure (formulae J to O in the following diagrams);
a 5-membered heterocyclic group containing a hetero atom such as oxygen, silicon, nitrogen, sulfur and selenium (formulae 94 to 98 in the following diagrams);
a 5-membered ring-condensed heterocyclic group containing a hetero atom such as oxygen, silicon, nitrogen, sulfur and selenium (formulae 99 to 110 in the following diagrams);
a group in which 5-membered heterocyclic groups containing a hetero atom such as oxygen, silicon, nitrogen, sulfur and selenium are bonded to each other at the α positions of the hetero atoms to form a dimer or an oligomer (formulae 111 and 112 in the following diagrams);
a group in which a 5-membered heterocyclic group containing a hetero atom such as oxygen, silicon, nitrogen, sulfur and selenium is bonded to phenyl groups at the α position of the hetero atom (formulae 113 to 119 in the following diagrams); and
a group in which a 5-membered ring-condensed heterocyclic group containing a hetero atom such as oxygen, nitrogen and sulfur is substituted with a phenyl group, a furyl group, or a thienyl group (formulae 120 to 125 in the following diagrams).

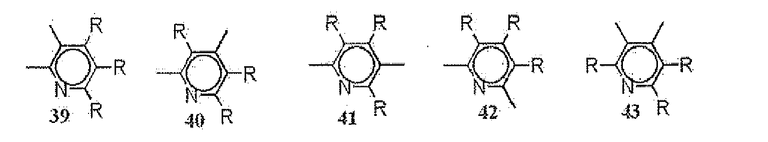

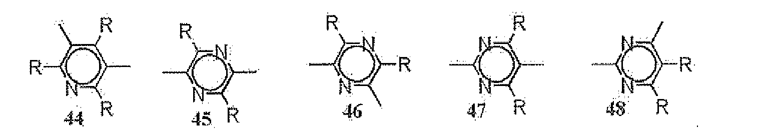

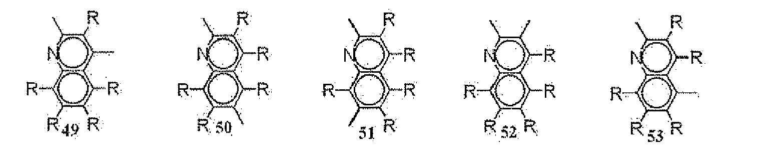

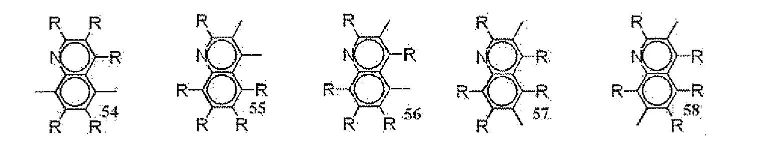

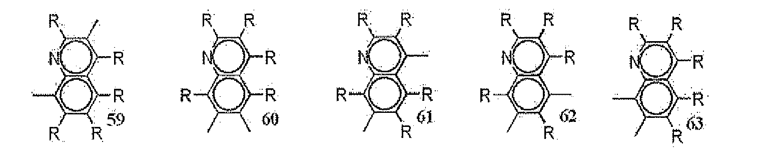

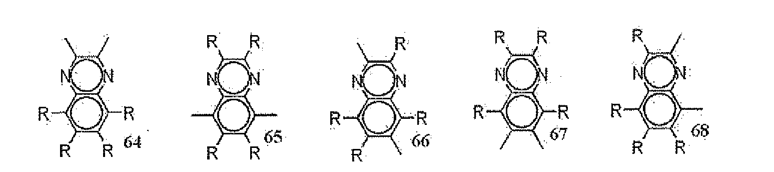

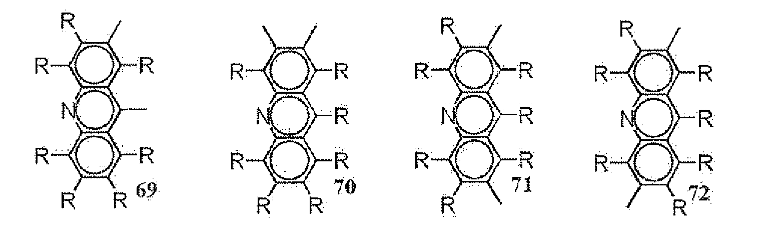

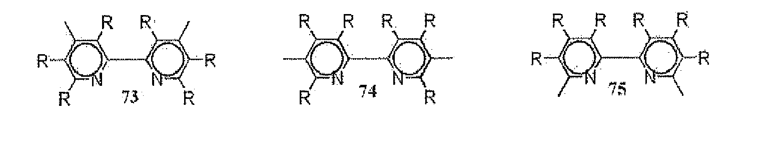

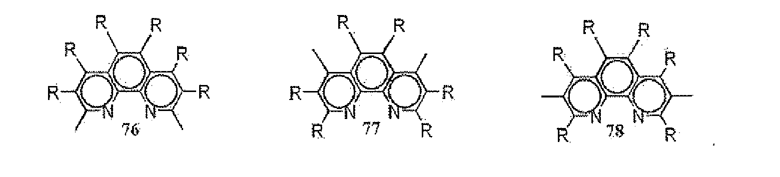

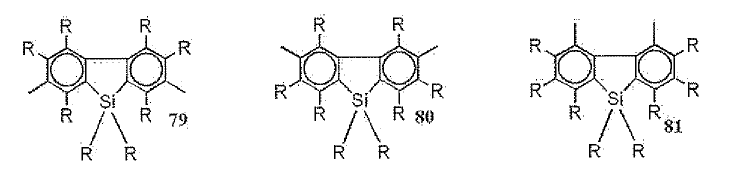

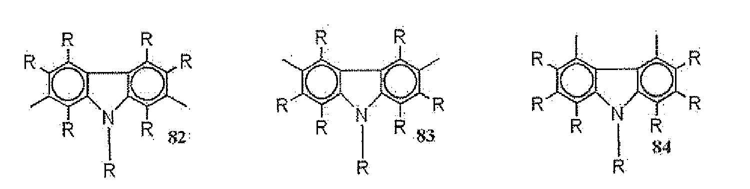

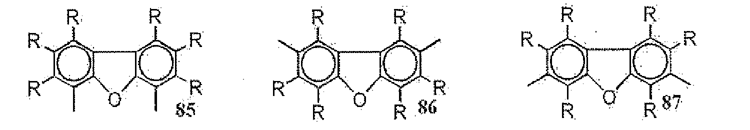

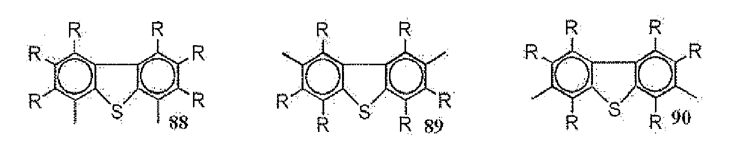

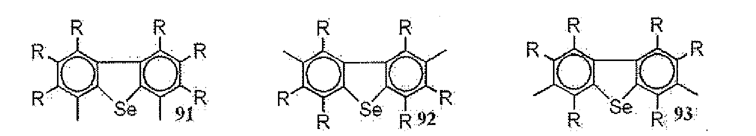

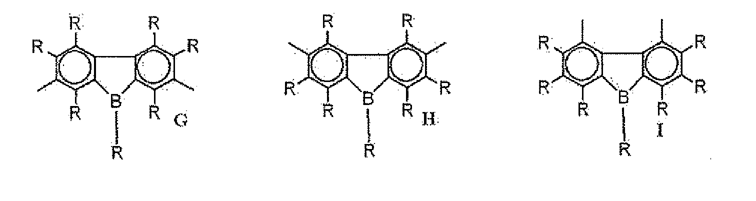

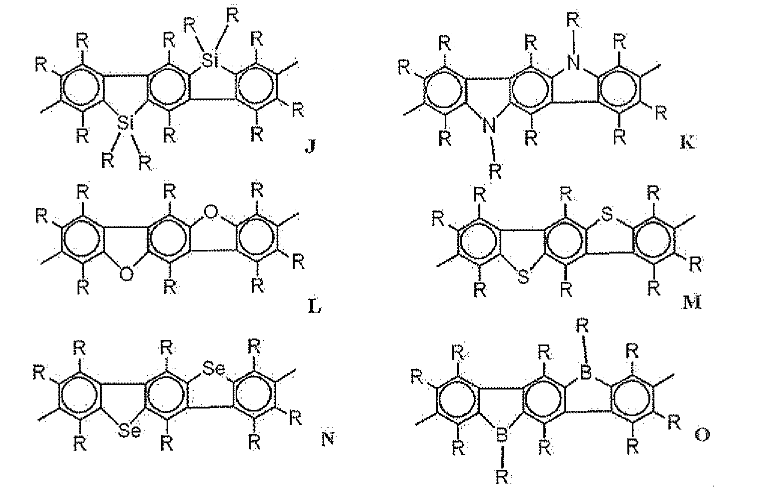

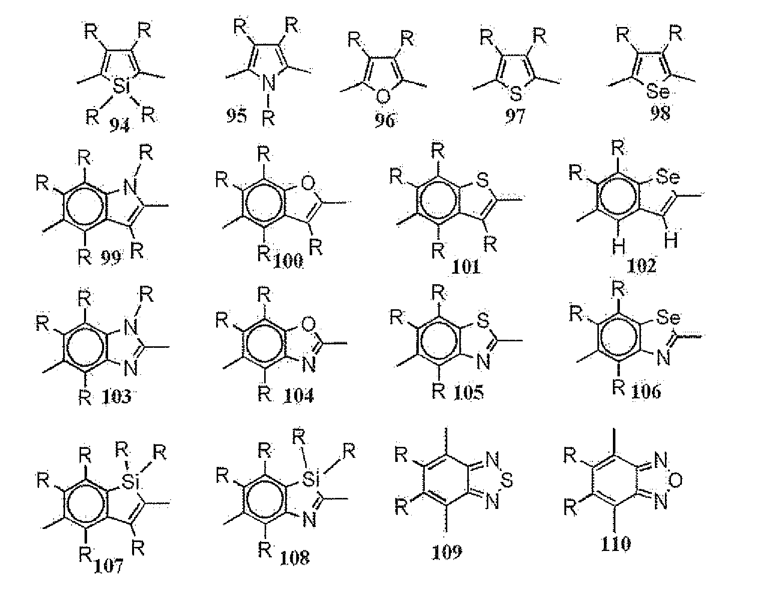

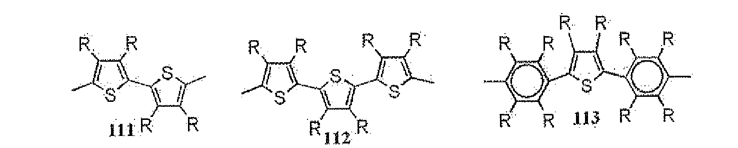

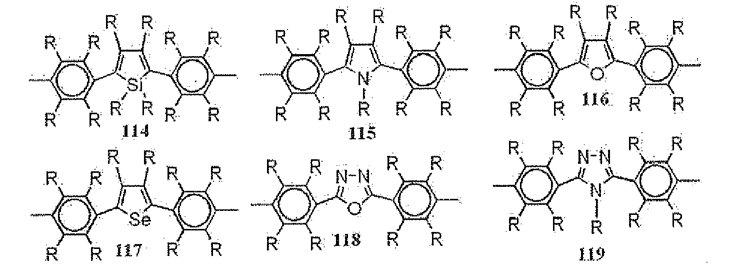

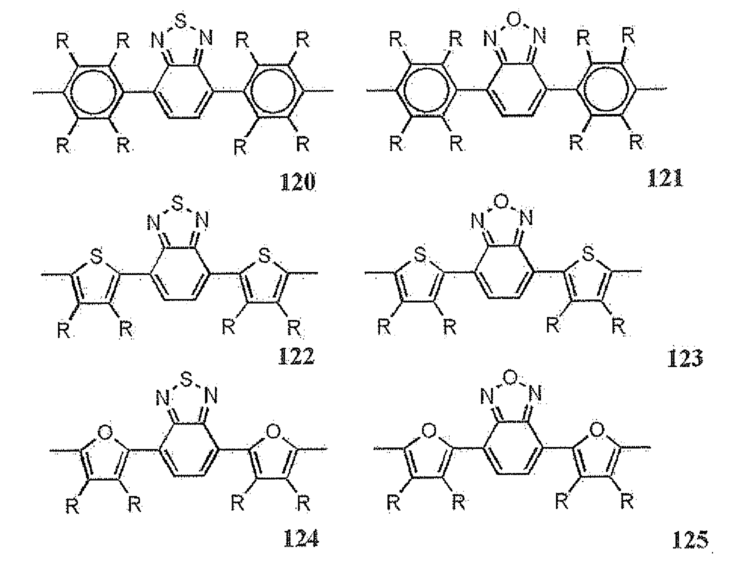

In the above formulae 1 to 125 and G to O, R each independently represent a hydrogen atom, an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, a substituted amino group, a silyl group, a substituted silyl group, a silyloxy group, a substituted silyloxy group, a halogen atom, an acyl group, an acyloxy group, an imine residue, an amido group, an acid imido group, a monovalent heterocyclic group, a carboxyl group, a substituted carboxyl group, a polymerizable substituent, or a cyano group.

In the above examples, each structural formula includes a plurality of R, and they may be the same as or different from each other. In order to improve the solubility in a solvent, it is preferable that at least one of the plurality of R contained in each structural formula is other than a hydrogen atom, and that the symmetry of each repeating unit including a substituent is low. Preferably, at least one of R in each structural formula is a group containing a cyclic or branched alkyl group. At least two of the plurality of R in each structural formula may be combined to form a ring.

In the above formulae, when R is a substituent having an alkyl group, the alkyl group may be any of linear, branched, and cyclic groups or may be a combination thereof. Examples of the non-linear alkyl groups may include an isoamyl group, a 2-ethylhexyl group, a 3,7-dimethyloctyl group, a cyclohexyl group, a 4-(C₁-C₁₂ alkyl)cyclohexyl group and the like.

In the group having an alkyl group, a methyl or methylene group in the alkyl group may be replaced with a hetero atom or a methyl or methylene group substituted with at least one fluorine atom. Examples of the hetero atom may include an oxygen atom, a sulfur atom, and a nitrogen atom.

The alkyl group may be any of linear, branched, and cyclic groups, and generally has about 1 to 20 carbon atoms. Examples of such an alkyl group may include a methyl group, an ethyl group, a propyl group, an i-propyl group, a butyl group, an i-butyl group, a t-butyl group, a sec-butyl group, a pentyl group, a hexyl group, a cyclohexyl group, a heptyl group, an octyl group, a 2-ethylhexyl group, a nonyl group, a decyl group, a 3,7-dimethyloctyl group, a lauryl group, a trifluoromethyl group, a pentafluoroethyl group, a perfluorobutyl group, a perfluorohexyl group, a perfluorooctyl group and the like. Of these, a pentyl group, a hexyl group, an octyl group, a 2-ethylhexyl group, a decyl group, and a 3,7-dimethyloctyl group are preferred.

The alkoxy group may be any of linear, branched, and cyclic groups, and generally has about 1 to 20 carbon atoms. Examples of such an alkoxy group may include a methoxy group, an ethoxy group, a propyloxy group, an i-propyloxy group, a butoxy group, an i-butoxy group, a t-butoxy group, a pentyloxy group, a hexyloxy group, a cyclohexyloxy group, a heptyloxy group, an octyloxy group, a 2-ethylhexyloxy group, a nonyloxy group, a decyloxy group, a 3,7-dimethyloctyloxy group, a lauryloxy group, a trifluoromethoxy group, a pentafluoroethoxy group, a perfluorobutoxy group, a perfluorohexyl group, a perfluorooctyl group, a methoxymethyloxy group, a 2-methoxyethyloxy group and the like. Of these, a pentyloxy group, a hexyloxy group, an octyloxy group, a 2-ethylhexyloxy group, a decyloxy group, and a 3,7-dimethyloctyloxy group are preferred.

The alkylthio group may be any of linear, branched, and cyclic groups, and generally has about 1 to 20 carbon atoms. Examples of such an alkylthio group may include a methylthio group, an ethylthio group, a propylthio group, an i-propylthio group, a butylthio group, an i-butylthio group, a t-butylthio group, a pentylthio group, a hexylthio group, a cyclohexylthio group, a heptylthio group, an octylthio group, a 2-ethylhexylthio group, a nonylthio group, a decylthio group, a 3,7-dimethyloctylthio group, a laurylthio group, a trifluoromethylthio group and the like. Of these, a pentylthio group, a hexylthio group, an octylthio group, a 2-ethylhexylthio group, a decylthio group, and a 3,7-dimethyloctylthio group are preferred.

The aryl group generally has about 6 to 60 carbon atoms, and examples of such an aryl group may include a phenyl group, a C₁-C₁₂ alkoxy phenyl group (C₁-C₁₂ represents that the number of carbon atoms is from 1 to 12. The same shall apply hereinafter.), a C₁-C₁₂ alkyl phenyl group, a 1-naphthyl group, a 2-naphthyl group, a 1-anthracenyl group, a 2-anthracenyl group, a 9-anthracenyl group, a pentafluorophenyl group, and a group having a benzocyclobutene structure (for example, a group represented by 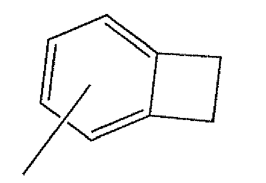 ). Of these, a C₁-C₁₂ alkoxy phenyl group and a C₁-C₁₂ alkyl phenyl group are preferred. The aryl group is an atomic group obtained by removing one hydrogen atom from an aromatic hydrocarbon. The aryl group may have a substituent. The aromatic hydrocarbon may include a hydrocarbon having a benzene ring or a condensed ring, and a hydrocarbon in which two or more independent benzene rings or condensed rings are bonded directly or via a group such as vinylene.

Specific examples of the C₁-C₁₂ alkoxy may include methoxy, ethoxy, propyloxy, i-propyloxy, butoxy, i-butoxy, t-butoxy, pentyloxy, hexyloxy, cyclohexyloxy, heptyloxy, octyloxy, 2-ethylhexyloxy, nonyloxy, decyloxy, 3,7-dimethyloctyloxy, and lauryloxy.

Specific examples of the C₁-C₁₂ alkyl may include methyl, ethyl, propyl, i-propyl, butyl, i-butyl, t-butyl, pentyl, hexyl, cyclohexyl, heptyl, octyl, 2-ethylhexyl, nonyl, decyl, 3,7-dimethyloctyl, and lauryl.

The aryloxy group generally has about 6 to 60 carbon atoms, and examples of such an aryloxy group may include a phenoxy group, a C₁-C₁₂ alkoxyphenoxy group, a C₁-C₁₂ alkylphenoxy group, a 1-naphthyloxy group, a 2-naphthyloxy group, and a pentafluorophenyloxy group. Of these, a C₁-C₁₂ alkoxyphenoxy group and a C₁-C₁₂ alkylphenoxy group are preferred.

The arylthio group generally has about 6 to 60 carbon atoms, and examples of such an arylthio group may include a phenylthio group, a C₁-C₁₂ alkoxyphenylthio group, a C₁-C₁₂ alkylphenylthio group, a 1-naphthylthio group, a 2-naphthylthio group, a pentafluorophenylthio group and the like. Of these, a C₁-C₁₂ alkoxyphenylthio group and a C₁-C₁₂ alkylphenylthio group are preferred.

The arylalkyl group generally has about 7 to 60 carbon atoms, and examples of such an arylalkyl group may include a phenyl-C₁-C₁₂ alkyl group such as a phenyl methyl group, a phenyl ethyl group, a phenyl butyl group, a phenyl pentyl group, a phenyl hexyl group, a phenyl heptyl group and a phenyl octyl group; a C₁-C₁₂ alkoxy phenyl-C₁-C₁₂ alkyl group; a C₁-C₁₂ alkyl phenyl-C₁-C₁₂ alkyl group; a 1-naphthyl-C₁-C₁₂ alkyl group; a 2-naphthyl-C₁-C₁₂ alkyl group and the like. Of these, a C₁-C₁₂ alkoxy phenyl-C₁-C₁₂ alkyl group and a C₁-C₁₂ alkyl phenyl-C₁-C₁₂ alkyl group are preferred.

The arylalkoxy group generally has about 7 to 60 carbon atoms, and examples of such an arylalkoxy group may include a phenyl-C₁-C₁₂ alkoxy group such as a phenyl methoxy group, a phenyl ethoxy group, a phenyl butoxy group, a phenyl pentyloxy group, a phenyl hexyloxy group, a phenyl heptyloxy group and a phenyl octyloxy group; a C₁-C₁₂ alkoxy phenyl-C₁-C₁₂ alkoxy group, a C₁-C₁₂ alkyl phenyl-C₁-C₁₂ alkoxy group, a 1-naphthyl-C₁-C₁₂ alkoxy group, a 2-naphthyl-C₁-C₁₂ alkoxy group and the like. Of these, a C₁-C₁₂ alkoxy phenyl-C₁-C₁₂ alkoxy group and a C₁-C₁₂ alkyl phenyl-C₁-C₁₂ alkoxy group are preferred.

The arylalkylthio group generally has about 7 to 60 carbon atoms, and examples of such an arylalkylthio group may include a phenyl-C₁-C₁₂ alkylthio group, a C₁-C₁₂ alkoxy phenyl-C₁-C₁₂ alkylthio group, a C₁-C₁₂ alkyl phenyl-C₁-C₁₂ alkylthio group, a 1-naphthyl-C₁-C₁₂ alkylthio group, a 2-naphthyl-C₁-C₁₂ alkylthio group and the like. Of these, a C₁-C₁₂ alkoxy phenyl-C₁-C₁₂ alkylthio group and a C₁-C₁₂ alkyl phenyl-C₁-C₁₂ alkylthio group are preferred.

The arylalkenyl group generally has about 8 to 60 carbon atoms, and examples of such an arylalkenyl group may include a phenyl-C₂-C₁₂ alkenyl group, a C₁-C₁₂ alkoxy phenyl-C₂-C₁₂ alkenyl group, a C₁-C₁₂ alkyl phenyl-C₂-C₁₂ alkenyl group, a 1-naphthyl-C₂-C₁₂ alkenyl group, a 2-naphthyl-C₂-C₁₂ alkenyl group and the like. Of these, a C₁-C₁₂ alkoxy phenyl-C₂-C₁₂ alkenyl group and a C₁-C₁₂ alkyl phenyl-C₂-C₁₂ alkenyl group are preferred.

The arylalkynyl group generally has about 8 to 60 carbon atoms, and examples of such an arylalkynyl group may include a phenyl-C₂-C₁₂ alkynyl group, a C₁-C₁₂ alkoxy phenyl-C₂-C₁₂ alkynyl group, a C₁-C₁₂ alkyl phenyl-C₂-C₁₂ alkynyl group, a 1-naphthyl-C₂-C₁₂ alkynyl group, a 2-naphthyl-C₂-C₁₂ alkynyl group and the like. Of these, a C₁-C₁₂ alkoxy phenyl-C₂-C₁₂ alkynyl group and a C₁-C₁₂ alkyl phenyl-C₂-C₁₂ alkynyl group are preferred.

The substituted amino group may include an amino group substituted with one or two groups selected from among an alkyl group, an aryl group, an arylalkyl group and a monovalent heterocyclic group. The substituted amino group generally has about 1 to 60 carbon atoms, and examples of such a substituted amino group may include a methylamino group, a dimethylamino group, an ethylamino group, a diethylamino group, a propylamino group, a dipropylamino group, an i-propylamino group, a diisopropylamino group, a butylamino group, an i-butylamino group, a t-butylamino group, a pentylamino group, a hexylamino group, a cyclohexylamino group, a heptylamino group, an octylamino group, a 2-ethylhexylamino group, a nonylamino group, a decylamino group, a 3,7-dimethyloctylamino group, a laurylamino group, a cyclopentylamino group, a dicyclopentylamino group, a cyclohexylamino group, a dicyclohexylamino group, a pyrrolidyl group, a piperidyl group, a ditrifluoromethylamino group, a phenylamino group, a diphenylamino group, a C₁-C₁₂ alkoxyphenylamino group, a di (C₁-C₁₂ alkoxy phenyl)amino group, a di (C₁-C₁₂ alkyl phenyl)amino group, a 1-naphthylamino group, a 2-naphthylamino group, a pentafluorophenylamino group, a pyridylamino group, a pyridazinylamino group, a pyrimidylamino group, a pyrazylamino group, a triazylamino group, a phenyl-C₁-C₁₂ alkylamino group, a C₁-C₁₂ alkoxy phenyl-C₁-C₁₂ alkylamino group, a C₁-C₁₂ alkyl phenyl-C₁-C₁₂ alkylamino group, a di(C₁-C)₋₂ alkoxy phenyl-C₁-C₁₂ alkyl)amino group, a di (C₁-C₁₂ alkyl phenyl-C₁-C₁₂ alkyl)amino group, a 1-naphthyl-C₁-C₁₂ alkylamino group, a 2-naphthyl-C₁-C₁₂ alkylamino group, a carbazoyl group and the like.

The substituted silyl group may include a silyl group substituted with one, two, or three groups selected from among an alkyl group, an aryl group, an arylalkyl group and a monovalent heterocyclic group. The substituted silyl group generally has about 1, to 60 carbon atoms, and examples of such a substituted silyl group may include a trimethylsilyl group, a triethylsilyl group, a tripropylsilyl group, a tri-i-propylsilyl group, a dimethyl-i-propylsilyl group, a diethyl-i-propylsilyl group, a t-butylsilyldimethylsilyl group, a pentyldimethylsilyl group, a hexyldimethylsilyl group, a heptyldimethylsilyl group, an octyldimethylsilyl group, a 2-ethylhexyl-dimethylsilyl group, a nonyldimethylsilyl group, a decyldimethylsilyl group, a 3,7-dimethyloctyl-dimethylsilyl group, a lauryldimethylsilyl group, a phenyl-C₁-C₁₂ alkylsilyl group, a C₁-C₁₂ alkoxyphenyl-C₁-C₁₂ alkylsilyl group, a C₁-C₁₂ alkylphenyl-C₁-C₁₂ alkylsilyl group, a 1-naphthyl-C₁-C₁₂ alkylsilyl group, a 2-naphthyl-C₁-C₁₂ alkylsilyl group, a phenyl-C₁-C₁₂ alkyldimethylsilyl group, a triphenylsilyl group, a tri-p-xylylsilyl group, a tribenzylsilyl group, a diphenylmethylsilyl group, a t-butyldiphenylsilyl group, a dimethylphenylsilyl group, a trimethoxysilyl group, a triethoxysilyl group, a tripropyloxysilyl group, a tri-i-propylsilyl group, a dimethyl-i-propylsilyl group, a methyldimethoxysilyl group, an ethyldimethoxysilyl group and the like.

The substituted silyloxy group may include a silyloxy group substituted with one, two, or three groups selected from among an alkyl group, an aryl group, an arylalkyl group, and a monovalent heterocyclic group. The substituted silyloxy group generally has about 1 to 60 carbon atoms, and examples of such a substituted silyloxy group may include a trimethylsilyloxy group, a triethylsilyloxy group, a tripropylsilyloxy group, a tri-i-propylsilyloxy group, a dimethyl-i-propylsilyloxy group, a diethyl-i-propylsilyloxy group, a t-butyldimethylsilyloxy group, a pentyldimethylsilyloxy group, a hexyldimethylsilyloxy group, a heptyldimethylsilyloxy group, an octyldimethylsilyloxy group, a 2-ethylhexyl-dimethylsilyloxy group, a nonyldimethylsilyloxy group, a decyldimethylsilyloxy group, a 3,7-dimethyloctyl-dimethylsilyloxy group, a lauryldimethylsilyloxy group, a phenyl-C₁-C₁₂ alkylsilyloxy group, a C₁-C₁₂ alkoxy phenyl-C₁-C₁₂ alkylsilyloxy group, a C₁-C₁₂ alkyl phenyl-C₁-C₁₂ alkylsilyloxy group, a 1-naphthyl-C₁-C₁₂ alkylsilyloxy group, a 2-naphthyl-C₁-C₁₂ alkylsilyloxy group, a phenyl-C₁-C₁₂ alkyldimethylsilyloxy group, a triphenylsilyloxy group, a tri-p-xylylsilyloxy group, a tribenzylsilyloxy group, a diphenylmethylsilyloxy group, a t-butyldiphenylsilyloxy group, a dimethylphenylsilyloxy group, a trimethoxysilyloxy group, a triethoxysilyloxy group, a tripropyloxysilyloxy group, a tri-i-propylsilyloxy group, a dimethyl-i-propylsilyloxy group, a methyldimethoxysilyloxy group, an ethyldimethoxysilyloxy group and the like.

Examples of the halogen atom may include a fluorine atom, a chlorine atom, a bromine atom, and an iodine atom.

The acyl group generally has about 2 to 20 carbon atoms, and examples of such an acyl group may include an acetyl group, a propionyl group, a butyryl group, an isobutyryl group, a pivaloyl group, a benzoyl group, a trifluoroacetyl group, a pentafluorobenzoyl group and the like.

The acyloxy group generally has about 2 to 20 carbon atoms, and examples of such an acyloxy group may include an acetoxy group, a propionyloxy group, a butyryloxy group, an isobutyryloxy group, a pivaloyloxy group, a benzoyloxy group, a trifluoroacetyloxy group, a pentafluorobenzoyloxy group and the like.

The imine residue may include a residue obtained by removing one hydrogen atom from an imine compound (the imine compound means an organic compound having -N=C- in the molecule thereof. Examples of the imine compound may include an aldimine, a ketimine, and a compound obtained by substituting a hydrogen atom on N in these compounds with, for example, an alkyl group). The imine residue has about 2 to 20 carbon atoms, and specific examples of such an imine residue may include the following groups (wavy lines represent bonding hand).

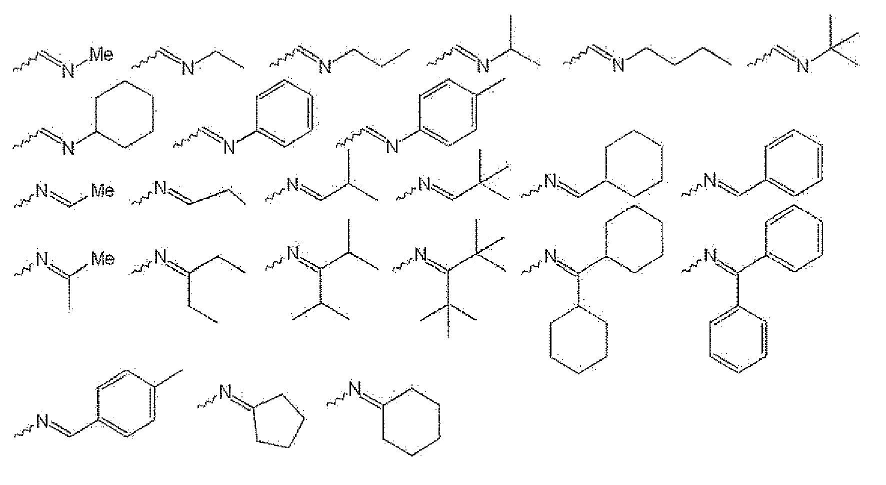

The amido group generally has about 1 to 20 carbon atoms, and examples of such an amido group may include a formamido group, an acetamido group, a propioamido group, a butyramido group, a benzamido group, a trifluoroacetamido group, a pentafluorobenzamido group, a diformamido group, a diacetamido group, a dipropioamido group, a dibutyramido group, a dibenzamido group, a ditrifluoroacetamido group, a dipentafluorobenzamido group and the like.

The acid imido group may include a residue obtained by removing, from an acid imide, the hydrogen atom bonded to the nitrogen atom in the acid imide. The acid imido group has about 4 to 20 carbon atoms, and specific examples of such an acid imido group may include the following groups. 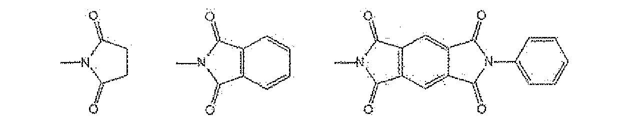 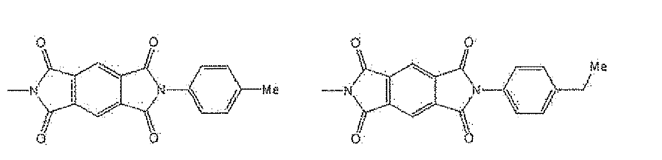 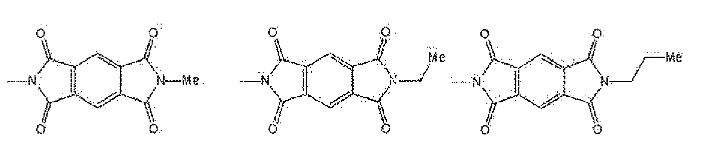 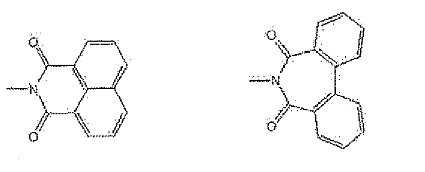 In the above examples, Me represents a methyl group.

The monovalent heterocyclic group means an atomic group obtained by removing one hydrogen atom from a heterocyclic compound, and the group may have a substituent.

The number of carbon atoms in an unsubstituted monovalent heterocyclic group is generally about 4 to 60, and preferably 4 to 20. A monovalent aromatic heterocyclic group is preferred as the monovalent heterocyclic group.

Examples of the monovalent heterocyclic group may include a thienyl group, a C₁-C₁₂ alkylthienyl group, a pyrrolyl group, a furyl group, a pyridyl group, a C₁-C₁₂ alkylpyridyl group and the like. Of these, a thienyl group, a C₁-C₁₂ alkylthienyl group, a pyridyl group, and a C₁-C₁₂ alkylpyridyl group are preferred.

The substituted carboxyl group may include a carboxyl group substituted with an alkyl group, an aryl group, an arylalkyl group, or a monovalent heterocyclic group. The substituted carboxyl group generally has about 2 to 60 carbon atoms, and examples of such a substituted carboxyl group may include a methoxycarbonyl group, an ethoxycarbonyl group, a propoxycarbonyl group, an i-propoxycarbonyl group, a butoxycarbonyl group, an i-butoxycarbonyl group, a t-butoxycarbonyl group, a pentyloxycarbonyl group, a hexyloxycarbonyl group, a cyclohexyloxycarbonyl group, a heptyloxycarbonyl group, an octyloxycarbonyl group, a 2-ethylhexyloxycarbonyl group, a nonyloxycarbonyl group, a decyloxycarbonyl group, a 3,7-dimethyloctyloxycarbonyl group, a dodecyloxycarbonyl group, a trifluoromethoxycarbonyl group, a pentafluoroethoxycarbonyl group, a perfluorobutoxycarbonyl group, a perfluorohexyloxycarbonyl group, a perfluorooctyloxycarbonyl group, a phenoxycarbonyl group, a naphthoxycarbonyl group, a pyridyloxycarbonyl group and the like.

In the formula (1) above, Ar¹, Ar², Ar³ and Ar⁴ each independently represent an arylene group optionally having a substituent or a divalent heterocyclic group optionally having a substituent. Ar¹, Ar², Ar³ and Ar⁴ are each preferably an arylene group optionally having a substituent, and more preferably a substituted or unsubstituted phenylene group, a substituted or unsubstituted biphenyldiyl group, a substituted or unsubstituted fluorene-diyl group, or a substituted or unsubstituted stilbene-diyl group shown below. Of these, an unsubstituted phenylene group is further preferred.

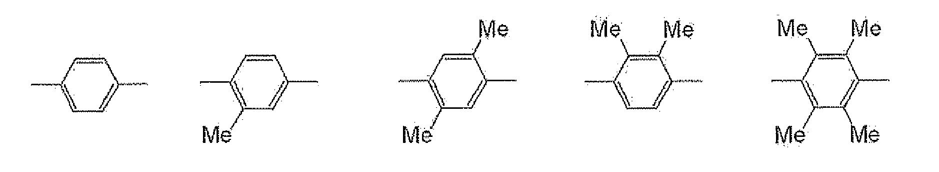

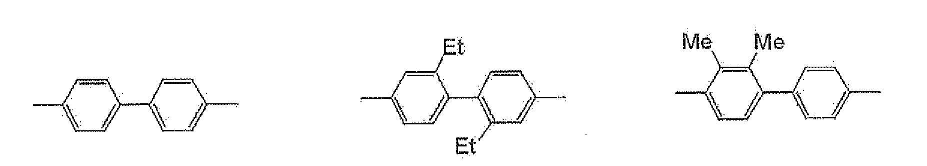

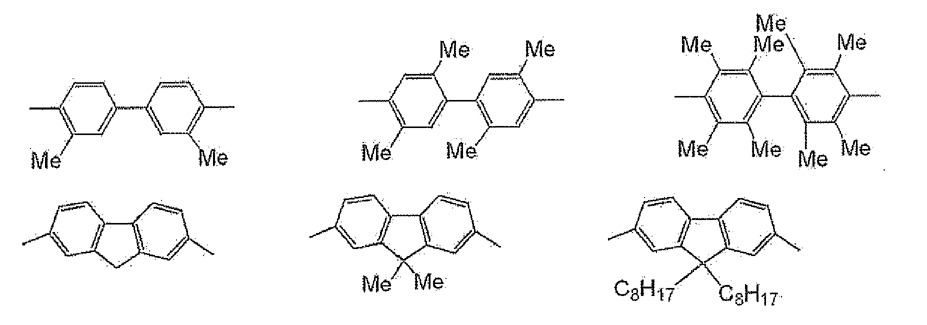

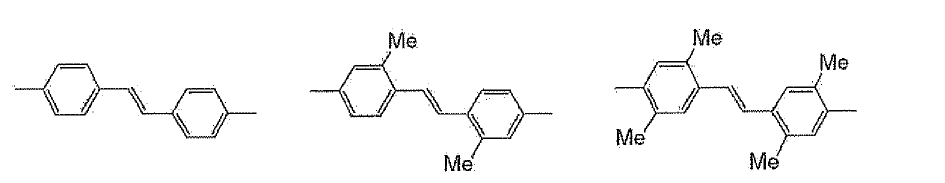

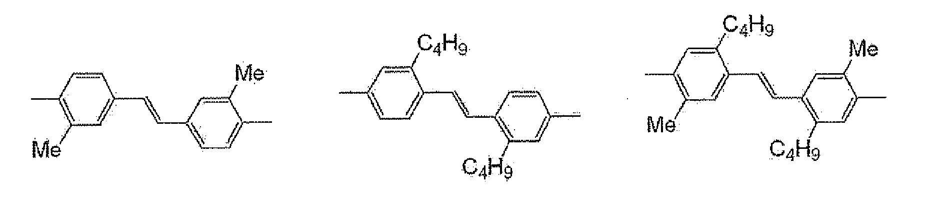

The repeating unit having an amine residue may include an arylene group having one or two or more substituents each including the group represented by the formula (1), and a divalent heterocyclic group having one or two or more substituents each including the group represented by the formula (1).

For the substituent including the group represented by the formula (1), the following groups are preferred.

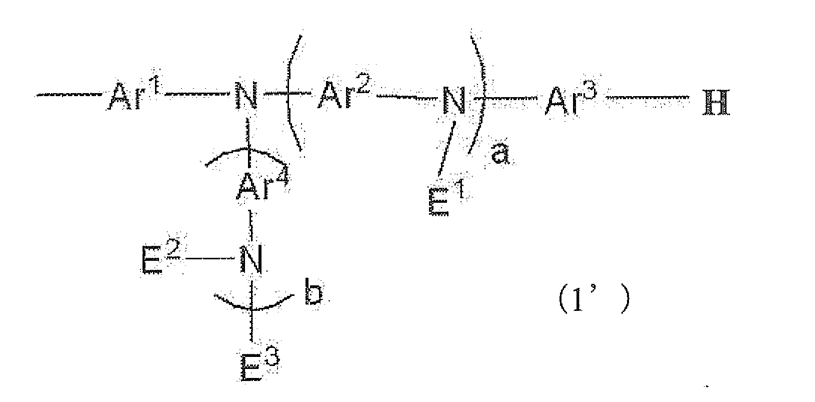

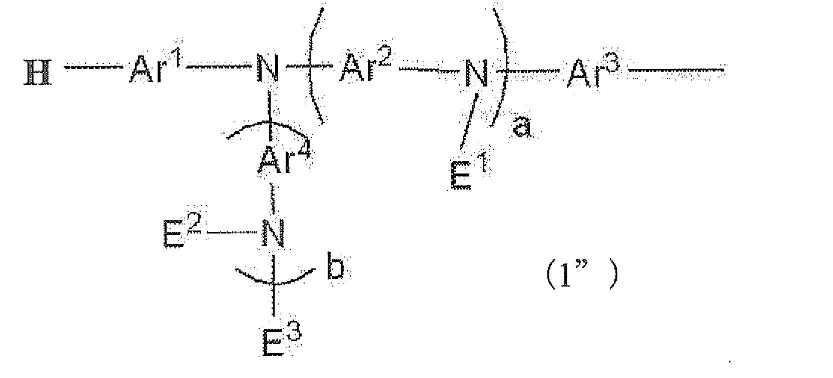

Specific examples of the repeating unit having an amine residue which constitutes the macromolecular compound contained in the functional layer in the present invention nay include the following repeating units.

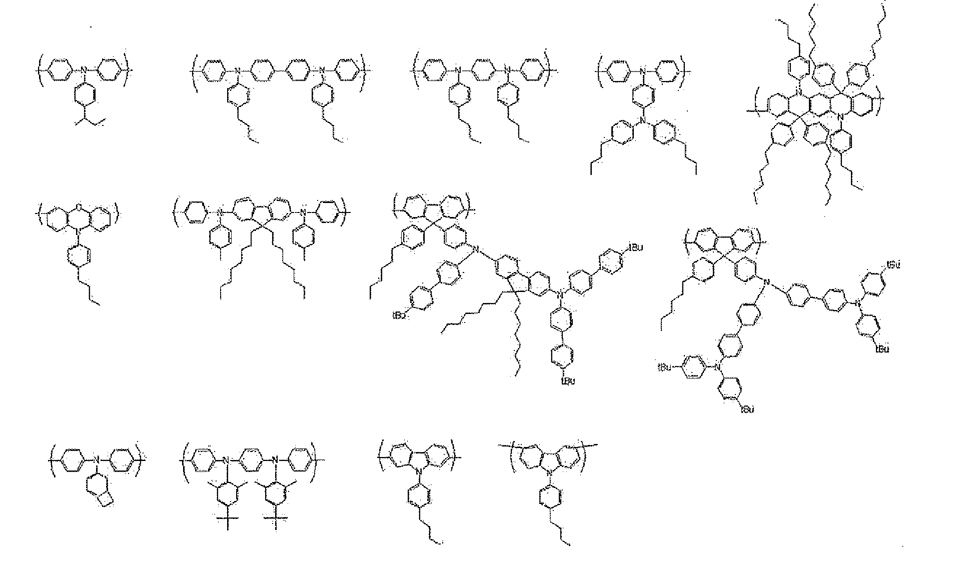

In the macromolecular compound comprising the repeating unit having an amine residue used in the present invention, the amount of the repeating unit represented by the formula (1) is generally from 1 mol% to 100 mol%, and more preferably from 10 mol% to 90 mol%, with respect to the total amount of repeating units contained in the macromolecular compound.

Preferably, the macromolecular compound comprising the repeating unit having an amine residue further comprises, in addition to the repeating unit represented by the formula (1), one or more types of repeating units selected from the group consisting of repeating units represented by the formula (2), (3), (4), or (5) below.

-Ar¹²- (2)

-Ar¹²-X¹-(Ar¹³-X²)_{c}-Ar¹⁴- (3)

-Ar¹²-X²- (4)

-X²- (5)

wherein Ar¹², Ar¹³ and Ar¹⁴ each independently represent an arylene group optionally having a substituent, a divalent heterocyclic group optionally having a substituent, or a divalent group having a metal complex structure; X¹ represents -CR²=CR³-, -C≡C-, or -(SiR⁵R⁶)_{d}-; X² represents - CR²=CR³-, -C≡C-, -N(R⁴)-, or -(SiR⁵R⁶)_{d}-; R² and R³ each independently represent a hydrogen atom, an alkyl group, an aryl group, a monovalent heterocyclic group, a carboxyl group, a substituted carboxyl group, or a cyano group; R⁴, R⁵ and R⁶ each independently represent a hydrogen atom, an alkyl group, an aryl group, a monovalent heterocyclic group, or an arylalkyl group; c represents an integer from 0 to 2; d represents an integer from 1 to 12; and when Ar¹³, R², R³, R⁵ and R⁶ are each plurally present, they may be the same as or different from each other.

The definitions and examples of the arylene group, divalent heterocyclic group, alkyl group, aryl group, monovalent heterocyclic group, carboxyl group, substituted carboxyl group, cyano group, and arylalkyl group in the above formulae (2) to (5) are the same as those described above.

The divalent group having a metal complex structure means a divalent group remaining after removing two hydrogen atoms from an organic ligand of a metal complex.

The organic ligand of the metal complex generally has about 4 to 60 carbon atoms. Examples of the organic ligand may include 8-quinolinol and a derivative thereof, benzoquinolinol and a derivative thereof, 2-phenyl-pyridine and a derivative thereof, 2-phenyl-benzothiazole and a derivative thereof, 2-phenyl-benzoxazole and a derivative thereof, and porphyrin and a derivative thereof.

Examples of a central metal of the metal complex having an organic ligand may include aluminum, zinc, beryllium, iridium, platinum, gold, europium, and terbium.

Examples of the metal complex having an organic ligand may include metal complexes which are known as low molecular weight fluorescent materials and phosphorescent materials, e.g., so-called triplet light-emitting complexes.

Examples of the divalent group having a metal complex structure may include the following groups (126 to 132).

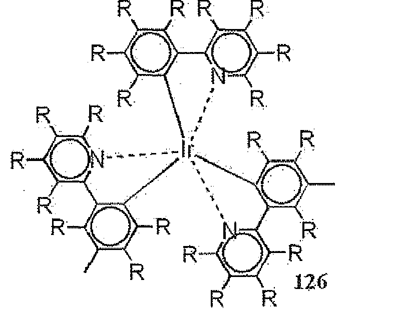

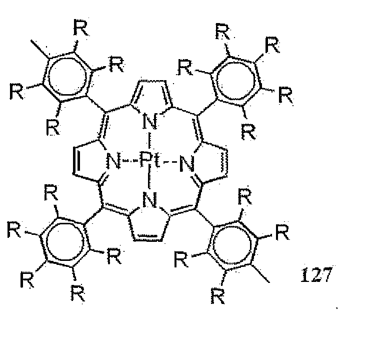

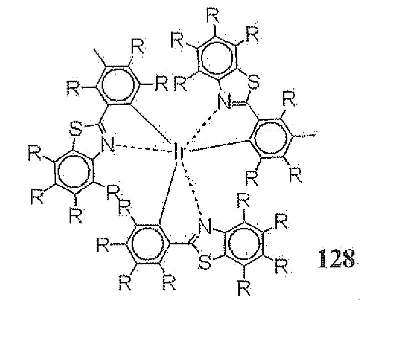

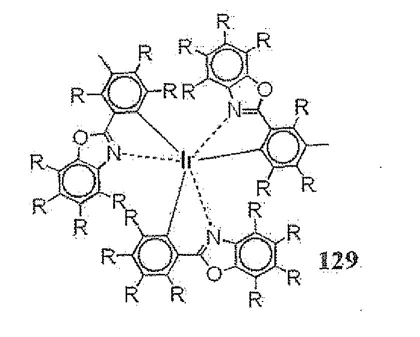

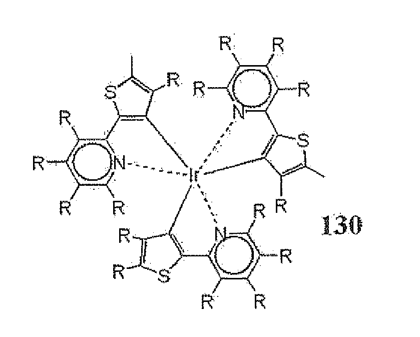

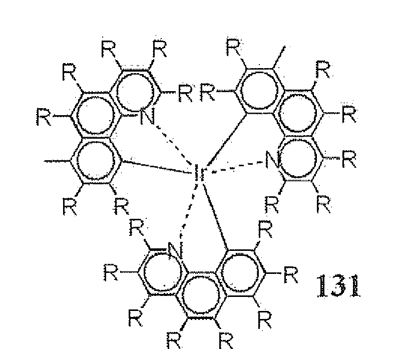

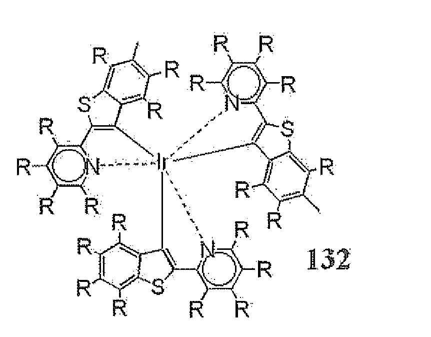

In these formulae, R have the same meaning as that of the R in the formulae 1 to 125 above.

The macromolecular compound used in the present invention may be a homopolymer having the repeating unit represented by the formula (1), or a copolymer with another repeating unit. The copolymer may be a random, alternating, block, or graft copolymer, or may be a polymer having a structure intermediate therebetween, e.g., a random copolymer with some block characteristics.

The macromolecular compound used in the present invention may include a compound that has a branch in the main chain and has three or more terminals, and dendrimers.

The macromolecular compound used in the present invention may be obtained by, for example, a method described in JP 2005-251734 A.

Preferably, in the organic EL element, the macromolecular compound comprising the repeating unit having an amine residue has been cross-linked by the action of heat or radiation such as light or an electron beam so as to be insoluble in a solvent. Therefore, the above macromolecular compound is preferably a macromolecular compound in which a compound having a polymerizable substituent is polymerized.

More specifically, it is preferable that the macromolecular compound comprising the repeating unit having an amine residue is a macromolecular compound in which a macromolecular compound that comprises a repeating unit having an amine residue and has a polymerizable substituent is polymerized.

The polymerizable substituent represents a substituent that can form a bond between two or more molecules through a polymerization reaction to generate a compound. Such a substituent may include a group having a carbon-carbon multiple bond (for example, a vinyl group, an acetylene group, a butenyl group, an acrylic group, an acrylate group, an acrylamido group, a methacrylic group, a methacrylate group, a methacrylamido group, an allene group, an allyl group, a vinyl ether group, a vinyl amino group, a furyl group, a pyrrolyl group (a pyrrole group), a thienyl group (a thiophene group), a silolyl group (a silole group), a group having a benzocyclobutene group structure, and the like); a group having a small ring (for example, cyclopropane (a cyclopropyl group), cyclobutane, (a cyclobutyl group), oxirane (an epoxy group), oxetane (an oxetane group), diketene (a diketene group), thiirane (an episulfide group), and the like); a lactone group; a lactam group; a group containing a siloxane derivative, and the like. In addition to the above groups, combinations of groups capable of forming an ester bond or an amido bond can also be used. Examples of the combinations may include a combination of an ester group and an amino group and a combination of an ester group and a hydroxyl group.

Preferred examples of the polymerizable substituent may include the following groups.

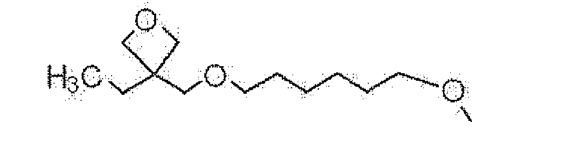

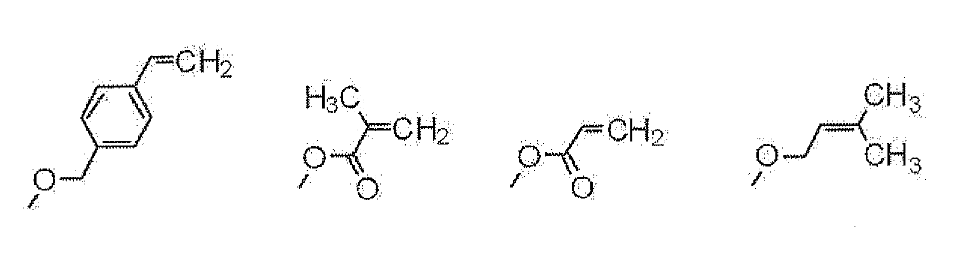

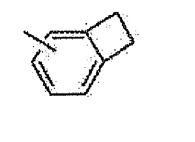

The functional layer comprises an n-type semiconductor, in addition to the above-described macromolecular compound comprising a repeating unit having an amine residue. Particularly, the functional layer is preferably composed substantially of an n-type semiconductor and the above-described macromolecular compound comprising the above-described repeating unit having an amine residue.

The n-type semiconductor is an n-type semiconductor when assuming that the above-described macromolecular compound comprising a repeating unit having an amine residue is a p-type semiconductor. The n-type semiconductor means an organic semiconductor (an n-type organic semiconductor) having LUMO (lowest unoccupied molecular orbital) and HOMO (highest occupied molecular orbital) energy levels lower than the LUMO and HOMO energy levels of the above-described macromolecular compound comprising a repeating unit having an amine residue, or means an inorganic semiconductor (an n-type inorganic semiconductor) having conduction band and valence band energy levels lower than the LUMO and HOMO energy levels of the above-described macromolecular compound comprising a repeating unit having an amine residue.

When the functional layer comprises such an n-type semiconductor, the element life of the organic EL element can be improved.

The light emitted from the organic EL element is mainly generated in the light-emitting layer. However, light may be generated in the functional layer. The undesirable light generation in the functional layer may be one of the causes of the deterioration of the functional layer. Therefore, to suppress the light generation in the functional layer, it is contemplated that the light generation by excitons generated in the functional layer is suppressed. More specifically, the charge separation of the excitons is facilitated by allowing the n-type semiconductor and the above-described macromolecular compound (p-type) comprising a repeating unit having an amine residue to coexist in the functional layer. This may allow the light emission from the macromolecular compound by excitons to be suppressed. As described above, the addition of the n-type semiconductor can suppress the light emission from the above-described macromolecular compound comprising a repeating unit having an amine residue, i.e., allows quenching to occur in the light from the macromolecular compound. This may suppress the deterioration of the macromolecular compound comprising a repeating unit having an amine residue, resulting in the extension of the life of the organic EL element. Therefore, it is preferable that the n-type semiconductor contained in the functional layer is an n-type semiconductor that can suppress the light generation in the functional layer. For example, an n-type semiconductor that can reduce the PL (photoluminescent) intensity when added is preferred. More specifically, a preferred n-type semiconductor for adding to the functional layer is as follows. A comparative functional layer (i) comprising no n-type semiconductor and a functional layer (ii) comprising the n-type semiconductor, i.e., obtained by adding the n-type semiconductor to the functional layer (i), are formed. Then these functional layers are irradiated with UV (ultraviolet) light as excitation light, and the PL (photoluminescent) intensities in the visible range are compared to each other. When the PL intensity of the functional layer (ii) is lower than that of the functional layer (i), the n-type semiconductor added is preferred (see Reference Examples 1 and 2 described later).

The n-type organic semiconductor may include: (I) a derivative of perylene tetracarboxylic diimide or naphthalene tetracarboxylic diimide (PTCDI or NTCDI), a derivative of perylene tetracarboxylic dianhydride or naphthalene tetracarboxylic dianhydride (PTCDA or NTCDA), and a derivative of perylene bisimidazole or naphthalene bisimidazole (PTCBI or NTCBI); (II) a fullerene and/or a fullerene derivative; (III) a phthalocyanine or a porphyrin having electron affinities improved by an electron-attracting substituent such as fluorine or chlorine; (IV) a quinone; (V) an oligomer, such as a fluorinated oligophenyl, having electron affinities improved by a substituent such as fluorine, chlorine, CF3 and CN; (VI) an oxadiazole derivative and the like. Preferably, these have a soluble group so as to be soluble in an organic solvent. Examples of such an n-type semiconductor may include an n-type semiconductor obtained by substituting hydrogen atoms bonded to two nitrogen atoms or carbon atoms in (a) perylene or naphthalene tetracarboxylic diimide (PTCDI or NTCDI) or (b) perylene or naphthalene tetracarboxylic dianhydride (PTCDA or NTCDA) with an alkyl group, an aryl group, a monovalent heterocyclic group, or an arylalkyl group.

Examples of the perylene or naphthalene tetracarboxylic diimide, derivatives of the perylene or naphthalene tetracarboxylic diimide, the perylene or naphthalene tetracarboxylic dianhydride, and derivatives of the perylene or naphthalene tetracarboxylic dianhydride may include compounds represented by the following formulae: 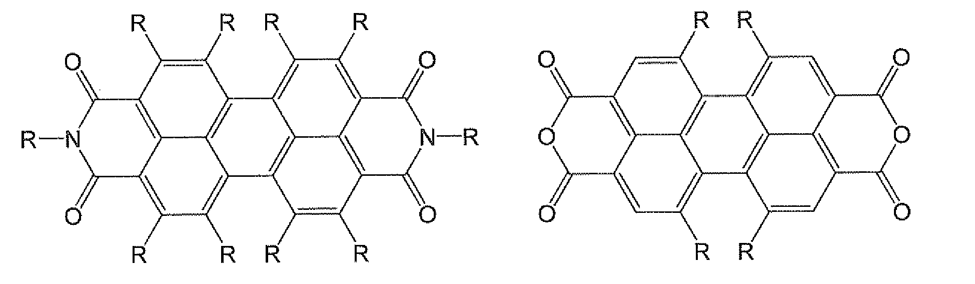 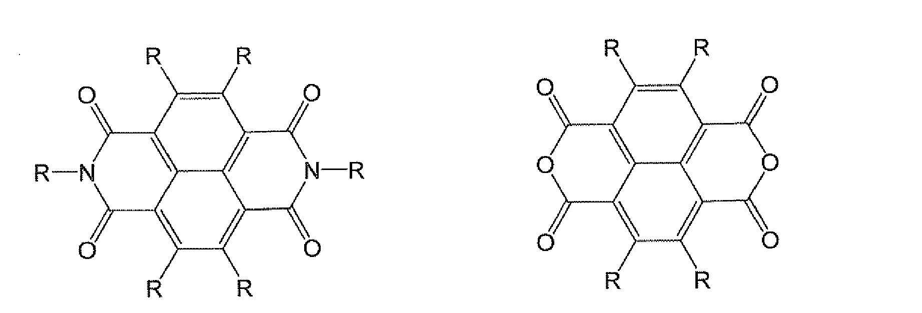 wherein R, which may be the same as or different from each other, represents a hydrogen atom, an alkyl group, an alkyloxy group, an alkylthio group, an aryl group, an aryloxy group, an arylthio group, an arylalkyl group, an arylalkyloxy group, or an arylalkylthio group.

The definitions, examples, etc. of the alkyl group, alkyloxy group, alkylthio group, aryl group, aryloxy group, arylthio group, arylalkyl group, arylalkyloxy group, and arylalkylthio group are the same as those for formula (1) above.

Specific examples may include the following.

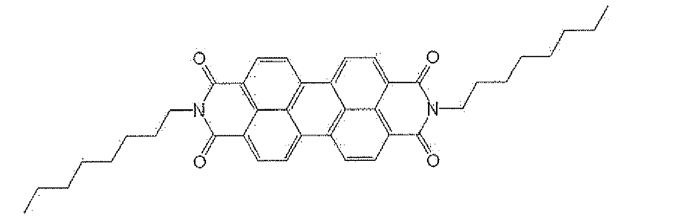

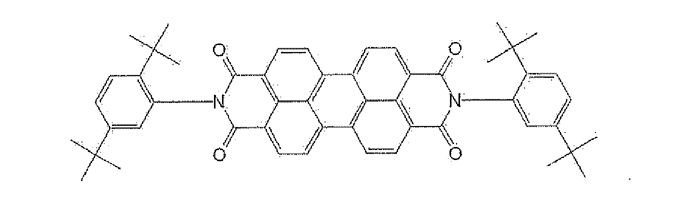

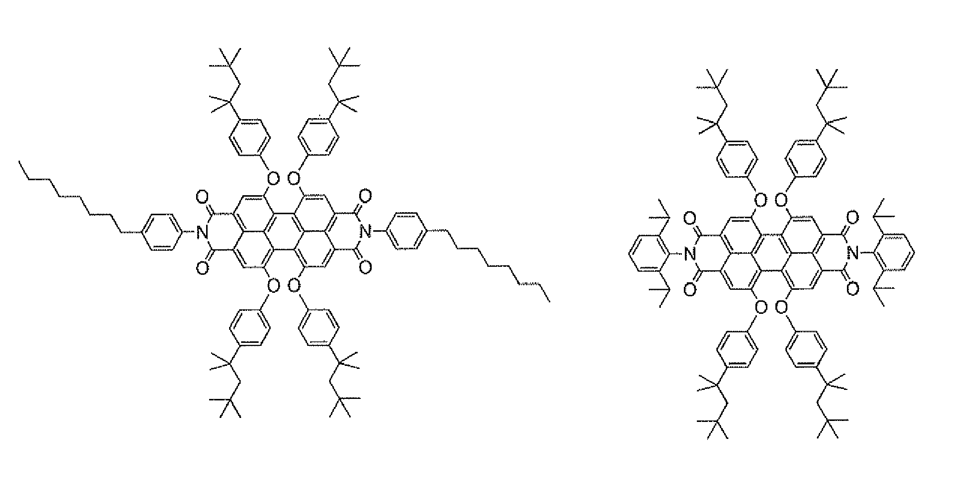

The n-type inorganic semiconductor may include metal oxides such as titanium oxide, zinc oxide, niobium oxide, and zirconium oxide. These can be obtained by dispersing, in an organic solvent, organic solvent-dispersible nanoparticles or nanofibers thereof formed so as to be dispersible in the organic solvent and drying after application, or can be obtained by dissolving a metal alkoxide that is a precursor in an organic solvent and converting it to a metal oxide after application.

The fullerene may include C₆₀, C₇₀, carbon nanotubes and the like. Examples of the fullerene derivatives may include a methanofullerene derivative, a PCBM derivative, a ThCBM derivative, a Prato derivative, a Bingel derivative, a diazoline derivative, an azafulleroid derivative, a ketolactam derivative, and a Diels-Alder derivative (for example, see JP 2009-542725 A).

### - Methanofullerene Derivative:

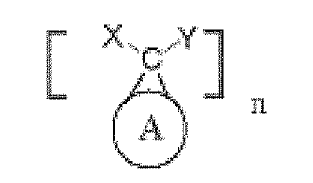

wherein A represents a fullerene skeleton (preferably, a C60 fullerene skeleton or a C70 fullerene skeleton);
the -C(X)(Y)- group is bonded to the fullerene skeleton via a methano crosslink; X and Y represent an aryl group having 6 to 60 carbon atoms, an alkyl group having 1 to 20 carbon atoms, or some other chemical groups (for example, an alkoxycarbonylalkyl group having 3 to 20 carbon atoms); and n represents 1 or 2.

Specific examples may include a compound (PCBM) in which X is an unsubstituted aryl and Y is a butyric acid methyl ester.

### - PCBM Derivative:

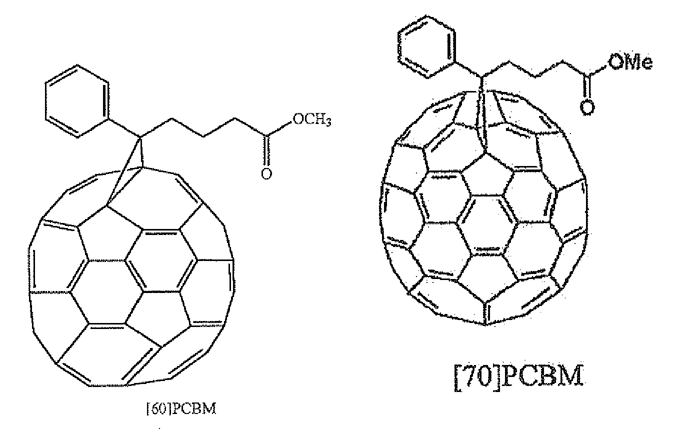

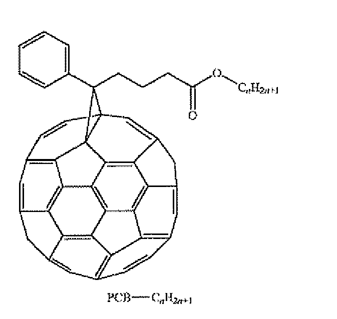

wherein n represents an integer from 1 to 20.

### - ThCBM Derivative:

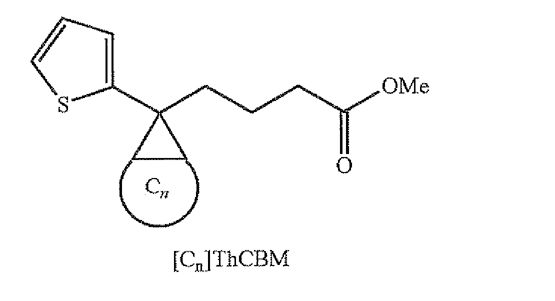

wherein Cn represents a fullerene skeleton (preferably, a C60 fullerene skeleton or a C70 fullerene skeleton).

### - Prato Derivative:

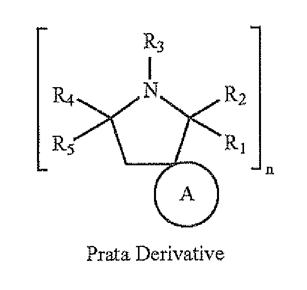

wherein A is a fullerene skeleton (preferably, a C60 fullerene skeleton or a C70 fullerene skeleton) bonded to - C(R4R5)-N(R3)-C(R1R2)-;
R1 is an optionally substituted aryl having 6 to 60 carbon atoms or aralkyl having 7 to 60 carbon atoms;
R2, R3, R4 and R5 are independently an optionally substituted alkyl having 1 to 20 carbon atoms, an optionally substituted cycloalkyl having 3 to 60 carbon atoms, an optionally substituted heteroalkyl having 1 to 20 carbon atoms, an optionally substituted heterocycloalkyl having 2 to 60 carbon atoms, an optionally substituted alkenyl having 1 to 20 carbon atoms, or an optionally substituted aralkyl having 7 to 60 carbon atoms; and
n is from 1 to 40.

Among these, 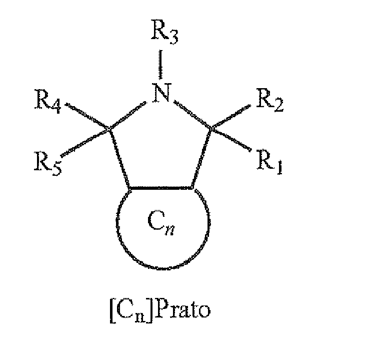 is preferred. Here, Cn represents a fullerene skeleton (preferably, a C60 fullerene skeleton or a C70 fullerene skeleton).

### - Bingel Derivative:

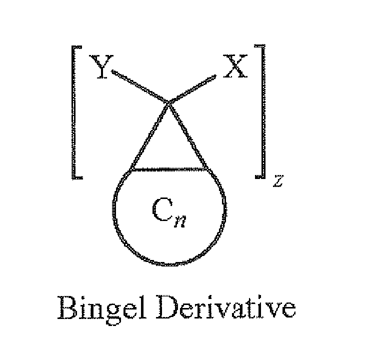

wherein
Cn represents a fullerene skeleton (preferably, a C60 fullerene skeleton or a C70 fullerene skeleton);
z is from 1 to 40;
X is an electron withdrawing group (EWG) such as an ester having 1 to 20 carbon atoms, a nitrile, a nitro, a cyano, a ketone having 1 to 20 carbon atoms, a dialkylphosphate having 2 to 20 carbon atoms, a (substituted) pyridine, and C-≡-C-R (also known as acetylene), wherein R is Si-(R)3 or a trisubstituted silyl group (which may be the same as or different from each other); and
Y is H, an aryl having 6 to 60 carbon atoms, a substituted aryl having 6 to 60 carbon atoms, an alkyl having 1 to 20 carbon atoms, or a substituted alkyl having 1 to 20 carbon atoms.

### - Azafulleroid Derivative:

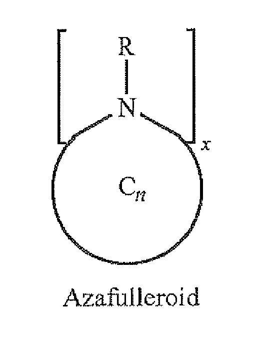

wherein
Cn represents a fullerene skeleton (preferably, a C60 fullerene skeleton or a C70 fullerene skeleton);
x is from 1 to 40; and
R is an alkyl having 1 to 20 carbon atoms, a substituted alkyl having 1 to 20 carbon atoms, an aryl having 6 to 60 carbon atoms, a substituted aryl having 6 to 60 carbon atoms, or S02-R', wherein R' is an alkyl having 1 to 20 carbon atoms, an aryl having carbon atoms, or a substituted aryl having 6 to 60 carbon atoms.

### - Diazoline Derivative:

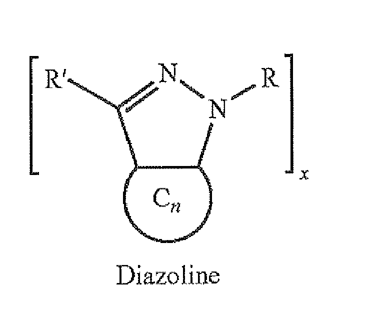

wherein
Cn represents a fullerene skeleton (preferably, a C60 fullerene skeleton or a C70 fullerene skeleton);
R and R' are independently an aryl having 6 to 60 carbon atoms; and
x is from 1 to 40.

### - Ketolactam Derivative:

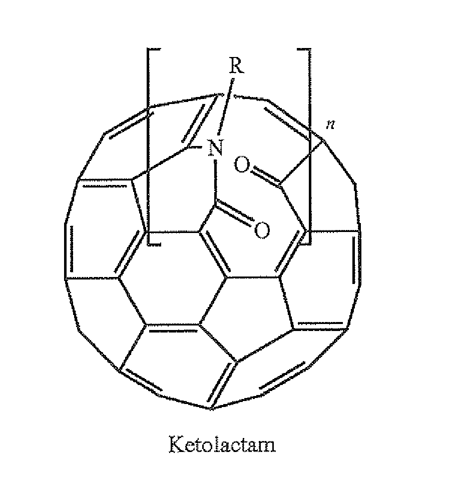

wherein
R is an alkyl or a substituted alkyl; and
n is from 1 to 40.

### - Diels-Alder Derivative:

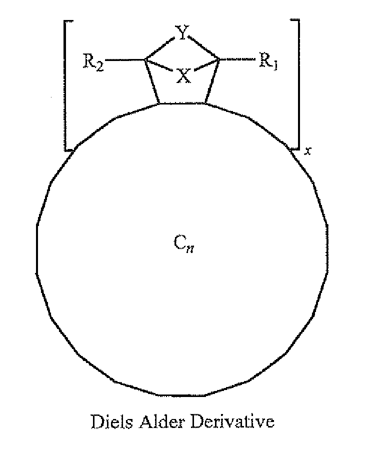

wherein
x is from 1 to 40;
Cn represents a fullerene skeleton (preferably, a C60 fullerene skeleton or a C70 fullerene skeleton);
R1 is H, an alkyl having 1 to 20 carbon atoms, an alkyloxy having 1 to 20 carbon atoms, an aryl having 6 to 60 carbon atoms, a substituted alkyl having 1 to 20 carbon atoms, a substituted aryl having 6 to 60 carbon atoms, a heteroaryl having 6 to 60 carbon atoms, or a substituted heteroaryl having 6 to 60 carbon atoms;
R2 is H, an alkyl having 1 to 20 carbon atoms, an alkyloxy having 1 to 20 carbon atoms, an aryl having 6 to 60 carbon atoms, a substituted alkyl having 1 to 20 carbon atoms, a substituted aryl having 6 to 60 carbon atoms, a heteroaryl having 6 to 60 carbon atoms, or a substituted heteroaryl having 6 to 60 carbon atoms;
X is O, an alkyl having 1 to 20 carbon atoms, a substituted alkyl having 1 to 20 carbon atoms, an aryl having 6 to 60 carbon atoms, a substituted aryl having 6 to 60 carbon atoms, a heteroaryl having 5 to 60 carbon atoms, or a substituted heteroaryl having 5 to 60 carbon atoms; and
Y represents an aryl having 6 to 60 carbon atoms, a substituted aryl having 6 to 60 carbon atoms, a heteroaryl having 5 to 60 carbon atoms, a substituted heteroaryl having 5 to 60 carbon atoms, a vinylene, or a substituted vinylene having 2 to 20 carbon atoms. 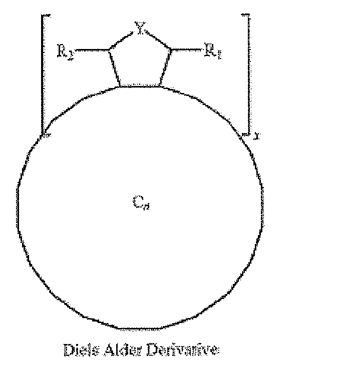
wherein
x is from 1 to 40;
Cn represents a fullerene skeleton (preferably, a C60 fullerene skeleton or a C70 fullerene skeleton);
R1 is H, an alkyl having 1 to 20 carbon atoms, an alkyloxy having 1 to 20 carbon atoms, an aryl having 6 to 60 carbon atoms, a substituted alkyl having 1 to 20 carbon atoms, a substituted aryl having 6 to 60 carbon atoms, a heteroaryl having 5 to 60 carbon atoms, or a substituted heteroaryl having 5 to 60 carbon atoms;
R2 is H, an alkyl having 1 to 20 carbon atoms, an alkyloxy having 1 to 20 carbon atoms, an aryl having 6 to 60 carbon atoms, a substituted alkyl having 1 to 20 carbon atoms, a substituted aryl having 6 to 60 carbon atoms, a heteroaryl having 5 to 60 carbon atoms, or a substituted heteroaryl having 5 to 60 carbon atoms; and
Y is an aryl having 6 to 60 carbon atoms, a substituted aryl having 6 to 60 carbon atoms, a heteroaryl having 5 to 60 carbon atoms, a substituted heteroaryl having 5 to 60 carbon atoms, a vinylene, or a substituted vinylene having 2 to 20 carbon atoms.

Specific examples may include the following.

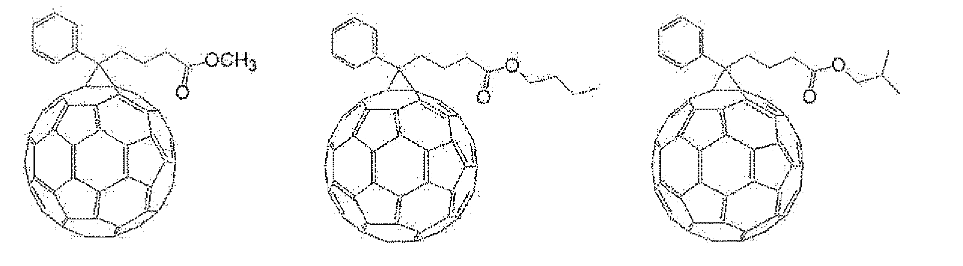

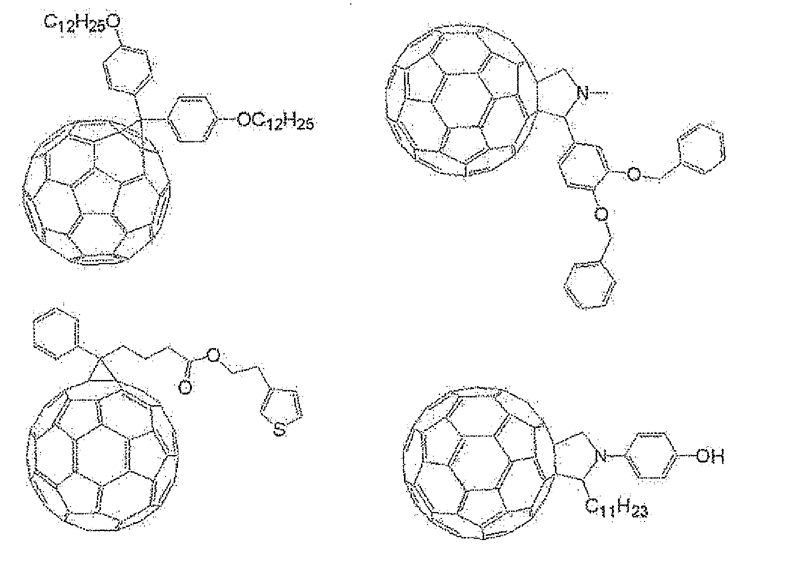

Preferably, as in the macromolecular compound comprising a repeating unit having an amine residue, each of the fullerene derivatives has been cross-linked by the action of heat or radiation such as light or an electron beam so as to be insoluble in a solvent. More specifically, in the functional layer, the fullerene derivative is preferably a macromolecular compound in which a compound comprising at least one polymerizable substituent in its molecule (specifically, a fullerene derivative comprising at least one polymerizable substituent in its molecule) is polymerized. Therefore, it is preferable to form the functional layer by forming a film which is to be the functional layer using a fullerene derivative having a polymerizable substituent and then polymerizing the compound in the film. The polymerizable substituent may include those described above.

Examples of the fullerene derivative having a polymerizable substituent before polymerization may include the following. The fullerene derivative before polymerization is a compound comprising a polymerizable substituent, and means a fullerene derivative before being polymerized with another compound.

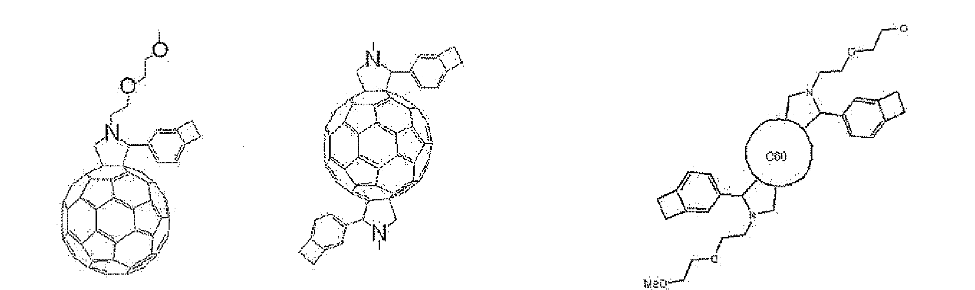

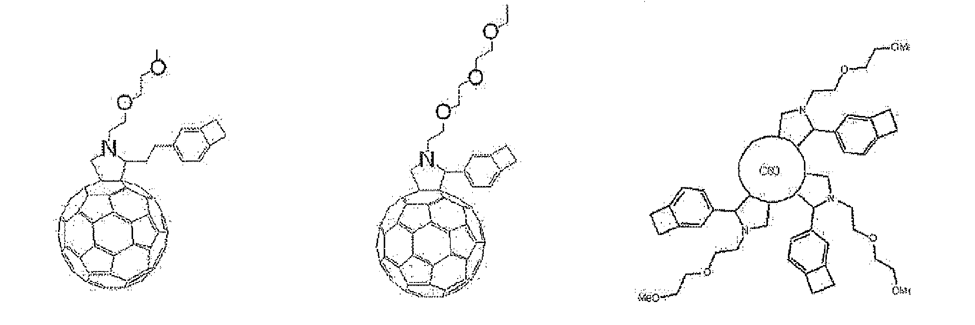

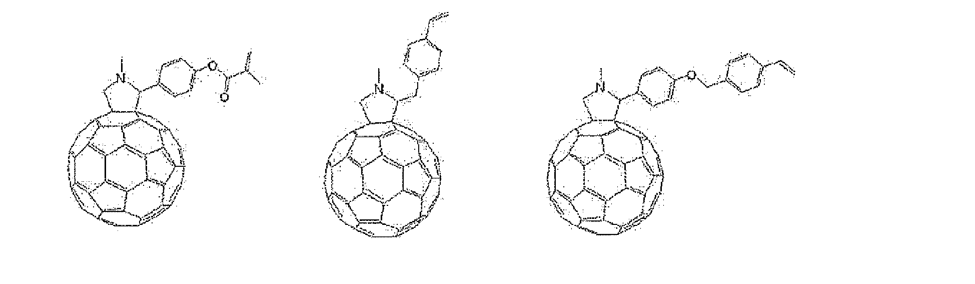

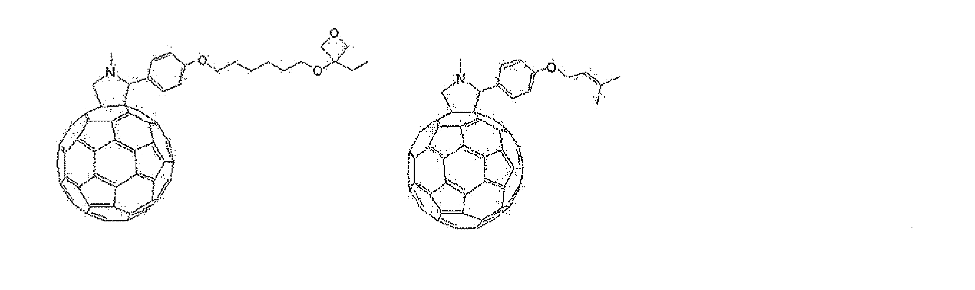

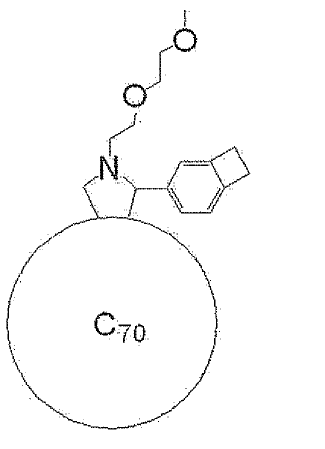

In the above compounds, the C60 ring (C60 skeleton) represents a fullerene ring (skeleton) having 60 carbon atoms, and the C70 ring (C70 skeleton) represents a fullerene ring (skeleton) having 70 carbon atoms.

The n-type organic semiconductor is not limited to the low molecular compounds described above and may be a macromolecular compound. The macromolecular n-type organic semiconductor may include a macromolecular compound having, as a repeating unit, the divalent residue of the low molecular n-type organic semiconductor described above. Examples of the repeating units constituting such a macromolecular n-type organic semiconductor may include the following.

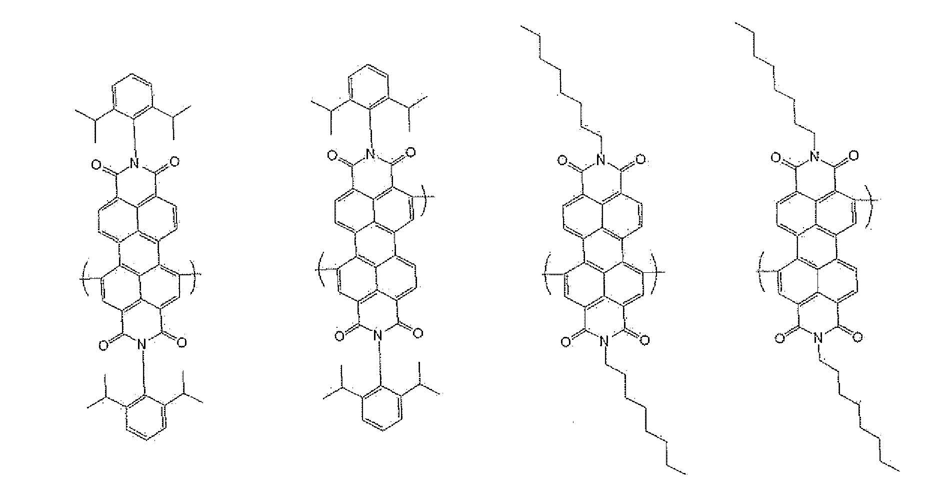

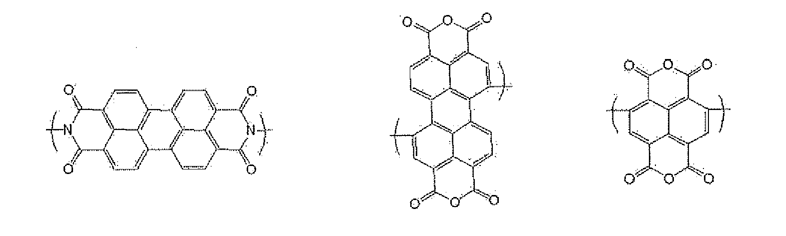

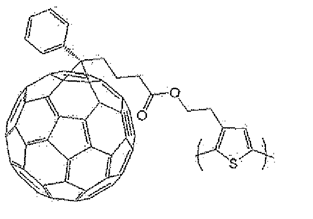

In each structural formula, a straight line crossing a parenthesis, i.e., a straight line crossing a parenthesis "(" or a parenthesis ")" represents a bond.

The macromolecular n-type organic semiconductor may also include a macromolecular compound comprising, as a substituent or a terminal group, the monovalent residue of the low molecular n-type organic semiconductor described above. Examples of the substituent and terminal group in such a macromolecular n-type organic semiconductor may include the following.

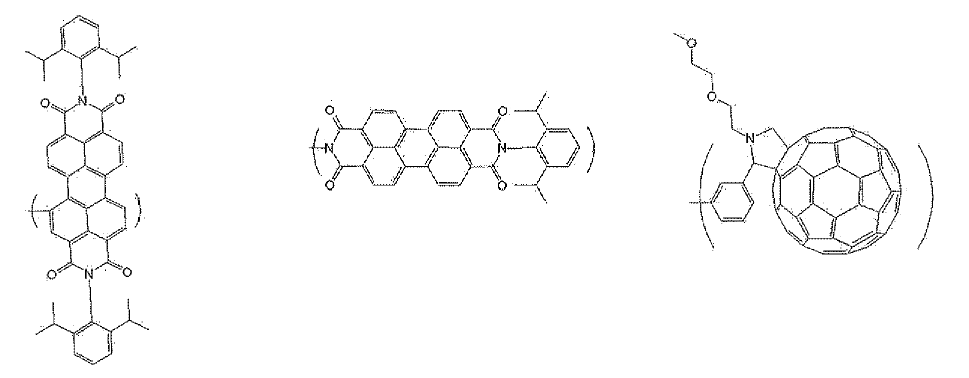

In each structural formula, a straight line crossing a parenthesis, i.e., a straight line crossing a parenthesis "(" or a parenthesis ")" represents a bond.

The divalent residue of the low molecular n-type organic semiconductors may be copolymerized with the macromolecular compound comprising a repeating unit having an amine residue. The monovalent residue of the low molecular n-type organic semiconductors may be bonded, as a substituent or a terminal group, to the macromolecular compound comprising a repeating unit having an amine residue.

Next, a description will be given of a light-emitting material used for the light-emitting layer in the organic EL element of the present invention. The light-emitting material may include a light-emitting material of a macromolecular compound and a light-emitting material of a low molecular compound. Of these, a light-emitting material of a macromolecular compound (macromolecular light-emitting body) is preferred.

The number average molecular weight of the macromolecular light-emitting body is generally from 10³ to 10⁸ in terms of polystyrene. Of these macromolecular light-emitting bodies, conjugated macromolecular compounds are preferred. The conjugated macromolecular compound means a macromolecular compound in which a delocalized π electron pair exists along the main chain skeleton of the macromolecular compound. As the delocalized electrons, unpaired electrons or a lone electron pair may participate in resonance instead of the double bond.

### <Conjugated Macromolecular Compound>

The conjugated macromolecular compound used in the present invention means: (1) a macromolecular compound that is substantially formed from a structure in which a double bond and a single bond alternate; (2) a macromolecular compound that is substantially formed from a structure in which a double bond and a single bond are arranged with a nitrogen atom interposed therebetween; and (3) a macromolecular compound that is substantially formed from a structure in which a double bond and a single bond alternate and a structure in which a double bond and a single bond are arranged with a nitrogen atom interposed therebetween. In the present specification, the conjugated macromolecular compound is specifically a macromolecular compound comprising one or two or more kinds of repeating units selected from the group consisting of an unsubstituted or substituted fluorenediyl group, an unsubstituted or substituted benzofluorenediyl group, an unsubstituted or substituted dibenzofurandiyl group, an unsubstituted or substituted dibenzothiophenediyl group, an unsubstituted or substituted carbazolediyl group, an unsubstituted or substituted thiophenediyl group, an unsubstituted or substituted furan diyl group, an unsubstituted or substituted pyrrolediyl group, an unsubstituted or substituted benzothiadiazolediyl group, an unsubstituted or substituted phenylenevinylenediyl group, an unsubstituted or substituted thienylenevinylenediyl group, and an unsubstituted or substituted triphenylaminediyl group, in which these repeating units are bonded to each other directly or via a linking group.

When the repeating units are bonded to each other via a linking group in the conjugated macromolecular compound, examples of the linking group may include phenylene, biphenylene, naphthalenediyl, anthracenediyl and the like.

It is preferable from the perspective of charge transport properties that the conjugated macromolecular compound used in the present invention has one or more types of repeating units selected from the group consisting of the formula (8) and the formula (9), 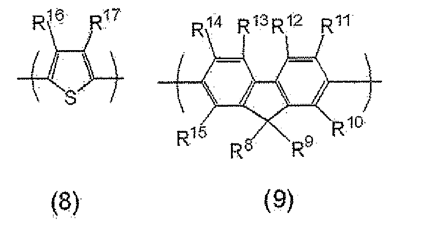 wherein R⁸, R⁹, R¹⁰, R¹¹, R¹², R¹³, R¹⁴, R¹⁵, R¹⁶ and R¹⁷, which are the same as or different from each other, represent a hydrogen atom, an alkyl group, an alkyloxy group, an alkylthio group, an aryl group, an aryloxy group, an arylthio group, an arylalkyl group, an arylalkyloxy group, or an arylalkylthio group.

Examples etc. of the alkyl group, aryl group, alkyloxy group, alkylthio group, aryloxy group, arylthio group, arylalkyl group, arylalkyloxy group, and arylalkylthio group represented by R⁸ to R¹⁷ in the formulae (8) and (9) are the same as the definitions, examples, etc. of those in the formula (1) above.

From the perspective of film-forming properties and solubility in the solvent, the weight average molecular weight of the conjugated macromolecular compound is preferably from 1 × 10³ to 1 × 10⁷, and more preferably from 1 × 10³ to 1 × 10⁶, in terms of polystyrene.

An organic layer included in the organic EL element of the present invention may contain one type or two or more types of conjugated macromolecular compounds.

The conjugated macromolecular compound can be produced by synthesizing the monomers having a functional group suited to the used polymerization reaction, then, if necessary, dissolving in an organic solvent, and polymerizing by, for example, a polymerization method such as known aryl coupling using an alkali, a suitable catalyst and a ligand.

### <Organic EL Element>

The organic EL element of the present invention is an organic EL element comprising a pair of electrodes composed of an anode and a cathode, a light-emitting layer provided between the electrodes, and a functional layer provided between the light-emitting layer and the anode, wherein the functional layer comprises an n-type semiconductor and a macromolecular compound comprising a repeating unit having an amine residue.

The organic EL element of the present invention is generally formed on a substrate. Preferably, the substrate is not chemically changed when the organic EL element is formed thereon. Examples of the material of the substrate may include glass, plastic, polymer film, and silicon. When an opaque substrate is used, it is preferable that one of the pair of electrodes that is disposed away from the substrate is a light-transmissive electrode. The organic EL element can generally be formed on the substrate by sequentially stacking each layer by a wet or dry process.

The ratio of the n-type semiconductor to the macromolecular compound comprising a repeating unit having an amine residue is generally from 0.001 to 1000 parts by weight, preferably from 0.01 to 100 parts by weight, more preferably from 0.01 to 80 parts by weight, and further preferably 0.01 to 50 parts by weight, with respect to 100 parts by weight of the macromolecular compound comprising a repeating unit having an amine residue.

The method for forming the functional layer may include a film formation method from a solution or dispersion that is prepared by dissolving or dispersing a composition comprising the n-type semiconductor and the macromolecular compound comprising a repeating unit having an amine residue.

The solvent used for the film formation from a solution is not particularly limited so long as the solvent can dissolve the above composition.

Examples of such a solvent may include: unsaturated hydrocarbon solvents such as toluene, xylene, mesitylene, tetralin, decalin, bicyclohexyl, n-butylbenzene, sec-butylbenzene and t-butylbenzene; halogenated saturated hydrocarbon solvents such as carbon tetrachloride, chloroform, dichloromethane, dichloroethane, chlorobutane, bromobutane, chloropentane, bromopentane, chlorohexane, bromohexane, chlorocyclohexane and bromocyclohexane; halogenated unsaturated hydrocarbon solvents such as chlorobenzene, dichlorobenzene and trichlorobenzene: and ether solvents such as tetrahydrofuran and tetrahydropyran. The composition used in the present invention can generally be dissolved in the above solvents in an amount of 0.1 percent by weight or more. The dispersion medium used for the film formation from a dispersion is not particularly limited so long as the dispersion medium can disperse the composition uniformly. For example, the above exemplified solvent may be used as the dispersion medium.

For the film formation from the solution, applying methods such as a spin coating method, a casting method, a micro-gravure coating method, a gravure coating method, a bar coating method, a roll coating method, a wire bar coating method, a dip coating method, a spray coating method, a screen printing method, a flexo printing method, an offset printing method, an ink-jet printing method, a dispenser printing method, a nozzle coating method, and a capillary coating method can be used. Of these, a spin coating method, a flexo printing method, an ink-jet printing method, and a dispenser printing method are preferred.

After forming the functional layer, it is preferable that the functional layer is subjected to heat or radiation such as light or an electron beam so that the polymerizable substituents undergo polymerization reaction, in order to make the functional layer insoluble in a solution used for forming the light-emitting layer and the like on the functional layer.

The light-emitting layer can be formed by a film formation method from a solution or dispersion prepared by dissolving or dispersing the macromolecular light-emitting body described above. The film formation method from a solution or dispersion is the same as the film formation method for the functional layer, and the solvent or dispersion medium used for the film formation method is appropriately selected according to the macromolecular light-emitting body. Even when the light-emitting body has a low molecular weight, the light-emitting layer may be formed using a film formation method from a solution or dispersion prepared by dissolving or dispersing the low molecular light-emitting body in a solvent or a dispersion medium.

The thickness of the light-emitting layer is generally from 1 nm to 100 µm, preferably from 2 nm to 1000 nm, more preferably from 5 nm to 500 nm, and further preferably from 20 nm to 200 nm.

In an organic EL element configured such that the light emitted from the light-emitting layer is emitted to the outside through the anode, a light-transmissive electrode is used for the anode. For the light-transmissive electrode, a thin film of a metal oxide, a metal sulfide, a metal or the like can be used, and a thin film having high electrical conductivity and high light transmittance is preferably used. Specifically, thin films made of indium oxide, zinc oxide, tin oxide, indium tin oxide (abbrev.: ITO), indium zinc oxide (abbrev.: IZO), gold, platinum, silver, copper and the like is used. Of these, a thin film made of ITO, IZO, or tin oxide is preferably used. The method for manufacturing the anode may include a vacuum deposition method, a sputtering method, an ion plating method, and a plating method. An organic transparent conductive film of, for example, polyaniline or derivatives thereof, polythiophene or derivatives thereof may also be used for the anode.

The thickness of the anode can be appropriately designed in consideration of the required properties and simplicity of process. The thickness is, for example, from 10 nm to 10 µm, preferably from 20 nm to 1 µm, and more preferably from 50 nm to 500 nm.

A material that has a low work function, facilitates electron injection into the light-emitting layer, and has a high electrical conductivity is preferred as a material of the cathode. In an organic EL element configured so that light is extracted from the anode side, a material having a high visible light reflectance is preferred as the material of the cathode material so that the light emitted from the light-emitting layer is reflected to the anode side by the cathode. For example, alkali metals, alkaline-earth metals, transition metals, and metals of Group 13 of the Periodic Table may be used for the cathode. Examples of the material of the cathode may include metals such as lithium, sodium, potassium, rubidium, cesium, beryllium, magnesium, calcium, strontium, barium, aluminum, scandium, vanadium, zinc, yttrium, indium, cerium, samarium, europium, terbium and ytterbium; an alloy of two kinds or more of these metals; alloys of two or more of the metals; alloys of one or more of the metals and one or more of gold, silver, platinum, copper, manganese, titanium, cobalt, nickel, tungsten and tin; and graphite or graphite intercalation compounds. Examples of the alloys may include a magnesium-silver alloy, a magnesium-indium alloy, a magnesium-aluminum alloy, an indium-silver alloy, a lithium-aluminum alloy, a lithium-magnesium alloy, a lithium-indium alloy, and a calcium-aluminum alloy. For the cathode, a transparent conductive electrode made of a conductive metal oxide, a conductive organic material or the like can be used. Specifically, the conductive metal oxide may include indium oxide, zinc oxide, tin oxide, ITO, and IZO, and the conductive organic material may include polyaniline or derivatives thereof and polythiophene or derivatives thereof. The cathode may be formed of a stacked body in which two or more layers are stacked. The electron injection layer may be used as the cathode.

The thickness of the cathode is appropriately designed in consideration of the required characteristics and the simplicity of the process, and the thickness is, for example, from 10 nm to 10 µm, preferably from 20 nm to 1 µm, and further preferably from 50 nm to 500 nm.

In the organic EL element, so-called a hole injection layer, a hole transport layer and the like serving as functional layers are provided between the anode and the light-emitting layer. Also between the light-emitting layer and the cathode, so-called an electron injection layer, an electron transport layer and the like are provided as necessary.

It is preferable from the perspective of extending life that the functional layer comprising the n-type semiconductor and the macromolecular compound comprising a repeating unit having an amine residue is provided in contact with the light-emitting layer.

Applicable layer structures of the organic EL element are exemplified below.
a) anode/hole injection layer/light-emitting layer/cathode
b) anode/hole injection layer/light-emitting layer/electron injection layer/cathode
c) anode/hole injection layer/light-emitting layer/electron transport layer/cathode
d) anode/hole injection layer/light-emitting layer/electron transport layer/electron injection layer/cathode
e) anode/hole transport layer/light-emitting layer/cathode
f) anode/hole transport layer/light-emitting layer/electron injection layer/cathode
g) anode/hole transport layer/light-emitting layer/electron transport layer/cathode
h) anode/hole transport layer/light-emitting layer/electron transport layer/electron injection layer/cathode
i) anode/hole injection layer/hole transport layer/light-emitting layer/cathode
j) anode/hole injection layer/hole transport layer/light-emitting layer/electron injection layer/cathode
k) anode/hole injection layer/hole transport layer/light-emitting layer/electron transport layer/cathode
l) anode/hole injection layer/hole transport layer/light-emitting layer/electron transport layer/electron injection layer/cathode

The electron transport layer and the electron injection layer can be formed using a general wet or dry process.

The material used for the electron transport layer may include oxadiazole derivatives, anthraquinodimethane and derivatives thereof, benzoquinone and derivatives thereof, naphthoquinone and derivatives thereof, anthraquinone and derivatives thereof, tetracyanoanthraquinodimethane and derivatives thereof, fluorenone derivatives, diphenyldicyanoethylene and derivatives thereof, diphenoquinone derivatives, metal complexes of 8-hydroxyquinoline and derivatives thereof, polyquinoline and derivatives thereof, polyquinoxaline and derivatives thereof, polyfluorene and derivatives thereof, and the like. The material used for the hole transport layer may include polyvinylcarbazole and derivatives thereof, polysilane and derivatives thereof, polysiloxane derivatives, macromolecular compounds having aromatic amine residue, polyaniline and derivatives thereof, polythiophene and derivatives thereof, poly(p-phenylene vinylene) and derivatives thereof, poly(2,5-thienylene vinylene) and derivatives thereof, and the like. For the material for forming the electron injection layer, the optimal material is appropriately selected according to the type of the light-emitting layer. Such a material may include: alkali metals; alkaline-earth metals; alloys containing at least one of alkali metals and alkaline-earth metals; oxides, halides, and carbonates of alkali metals and alkaline-earth metals; and mixtures of these materials. Examples of the alkali metals and the oxides, halides, and carbonates of the alkali metals may include lithium, sodium, potassium, rubidium, cesium, lithium oxide, lithium fluoride, sodium oxide, sodium fluoride, potassium oxide, potassium fluoride, rubidium oxide, rubidium fluoride, cesium oxide, cesium fluoride, and lithium carbonate. Examples of the alkaline-earth metals and the oxides, halides, and carbonates of the alkaline-earth metals may include magnesium, calcium, barium, strontium, magnesium oxide, magnesium fluoride, calcium oxide, calcium fluoride, barium oxide, barium fluoride, strontium oxide, strontium fluoride, and magnesium carbonate. The electron injection layer may be formed of a stacked body in which two or more layers are stacked, and an example of the stacked body may include LiF/Ca.

The organic EL element of the present invention may further comprise a buffer layer. The material used for the buffer layer may include halides and oxides of one or more metals selected from among alkali metals and alkaline-earth metals, and specifically, lithium fluoride.

Fine particles of an inorganic semiconductor such as titanium oxide may be used for the buffer layer.

### <Light-Emitting Device and Display Device comprising Organic EL Element>

The organic EL element described above can be preferably used in a light-emitting device such as a curved or a flat illumination device, e.g., a planar light source used as a light source for a scanner, and a display device, or in a display device.

The display device comprising an organic EL element may include a segment display device and a dot-matrix display device. Examples of the dot-matrix display device include an active matrix display device and a passive matrix display device. In an active matrix display device or a passive matrix display device, the organic EL element is used as the light-emitting element forming each pixel. In a segment display device, the organic EL element is used as the light-emitting element forming each segment. In a liquid crystal display device, the organic EL element is used as a backlight.

### Examples

Examples will now be illustrated in order to describe the present invention in more detail. However, the present invention is not limited to these examples.

### - Method for measuring molecular weight -

In the Examples, the number average molecular weight (Mn) and the weight average molecular weight (Mw) in terms of polystyrene were determined by gel permeation chromatography (GPC). Specifically, the molecular weight was measured at 40°C by GPC (trade name: HLC-8220GPC, manufactured by Tosoh Corporation) using three TSKgel SuperHM-H (manufactured by Tosoh Corporation) columns connected in series. Tetrahydrofuran was used as a developing solvent, and was flowed at a flow rate of 0.5 mL/min. A differential refractive index detector was used for the detector.

### <Synthesis Example 1> (Synthesis of macromolecular compound 1)

Into a 500 ml four-necked flask, 1.72 g of triscaprylylmethylammonium chloride (trade name: Aliquat 336 (registered trademark), a product of Aldrich), 6.2171 g of the compound A represented by the following formula,

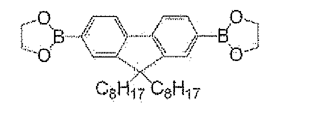

### Compound A

0.5085 g of the compound B represented by the following formula,

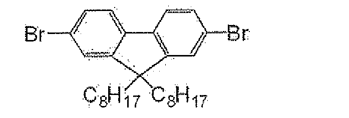

### Compound B

6.2225 g of the compound C represented by the following formula,

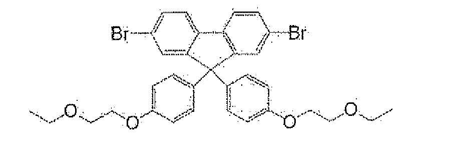

### Compound C

and 0.5487 g of the compound D represented by the following formula,

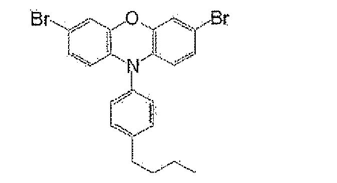

### Compound D

were charged, and then the flask was purged with nitrogen. One hundred milliliters of toluene was added, then 7.6 mg of dichlorobis(triphenylphosphine) palladium (II) and 24 ml of an aqueous solution of sodium carbonate were added, and the resultant mixture was stirred for 3 hours under reflux. Then, 0.40 g of phenylboric acid was added, and the mixture was stirred overnight. An aqueous solution of sodium N,N-diethyldithiocarbamate was added, and the mixture was further stirred for 3 hours under reflux. The resultant reaction liquid was then separated. The organic phase was washed with an acetic acid aqueous solution and water, and then added dropwise into methanol, whereby a precipitate was formed. The resultant precipitate was filtrated, dried under reduced pressure, dissolved in toluene, passed through a silica gel-alumina column, and then washed with toluene. The obtained toluene solution was added dropwise into methanol, whereby a precipitate was formed. The obtained precipitate was filtrated, dried under reduced pressure, and then dissolved in toluene. The resultant mixture was added dropwise into methanol, whereby a precipitate was formed. The obtained precipitate was filtrated, and dried under reduced pressure, thus obtaining 7.72 g of macromolecular compound 1 which is a conjugated macromolecular compound. The number average molecular weight Mn of the macromolecular compound 1 in terms of polystyrene was 1.2 × 10⁵, and the weight average molecular weight Mw in terms of polystyrene was 2.9 × 10⁵.

### <Synthesis Example 2> (Synthesis of macromolecular compound 2)

Into a 5 L separable flask, 40.18 g of triscaprylylmethylammonium chloride (trade name: Aliquat 336 (registered trademark), a product of Aldrich), 234.06 g of the compound E represented by the following formula,

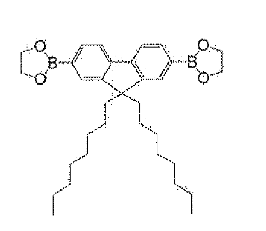

### Compound E

172.06 g of the compound F represented by the following formula,

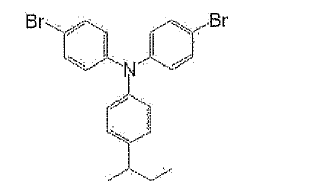

### Compound F

and 28.5528 g of the compound G represented by the following formula

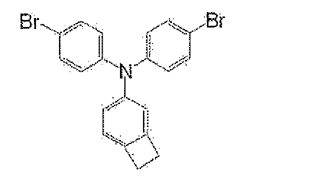

### Compound G

were charged, and then the flask was purged with nitrogen. Then, 2,620 g of toluene bubbled with argon was added, and the mixture was bubbled for further 30 minutes while stirring. Thereto, 99.1 mg of palladium acetate and 937.0 mg of tris(o-tolyl)phosphine were added. The mixture was rinsed with 158 g of toluene, and heated to 95°C. Next, 855 g of 17.5% by weight of an aqueous solution of sodium carbonate was added dropwise, and then a bath temperature was increased to 110°C. The mixture was stirred for 9.5 hours, and then a solution in which 5.39 g of phenylboric acid was dissolved in 96 ml of toluene was added. The mixture was stirred for 14 hours, and then 200 ml of toluene was added. The resultant reaction liquid was then separated. The organic phase was washed twice with 850 ml of 3% by weight of an aqueous solution of acetic acid, and then 850 ml of water and 19.89 g of sodium N,N-diethyldithiocarbamate were added, and the resultant mixture was stirred for 4 hours. After separating, the mixture was passed through a silica gel-alumina column, and then washed with toluene. The obtained toluene solution was added dropwise into 50 L of methanol, whereby a precipitate was formed. The obtained precipitate was washed with methanol, dried under reduced pressure, and then dissolved in 11 L of toluene. The obtained toluene solution was added dropwise into 50 L of methanol, whereby a precipitate was formed. The obtained precipitate was filtrated, and dried under reduced pressure, thus obtaining 278.39 g of macromolecular compound 2. The number average molecular weight Mn of the macromolecular compound 2 in terms of polystyrene was 7.7 × 10⁴, and the weight average molecular weight Mw in terms of polystyrene was 3.8 × 10⁵.

### (Synthesis of fullerene derivative before polymerization)

Commercially available reagents and solvents without any treatment or after distillation and purification in the presence of a drying agent were used for the synthesis of fullerene derivatives. A C₆₀ fullerene that is a product of Frontier Carbon Corporation was used. NMR spectra were measured by using MH500 manufactured by JEOL Ltd., and tetramethylsilane (TMS) was used as the internal standard. Infrared absorption spectra were measured by using FT-IR 8000 manufactured by Shimadzu Corporation.

### (Synthesis of benzyl [2-(2-hydroxyethoxy)ethylamino]acetate 2)

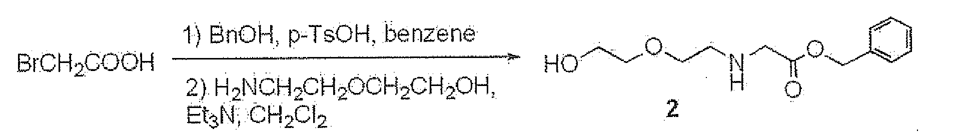

[First step]: A two-necked flask equipped with a Dean-Stark trap was charged with bromoacetic acid (20.8 g, 150 mmol), benzyl alcohol (16.2 g, 150 mmol), para-toluenesulfonic acid (258 mg, 1.5 mmol) and benzene (300 mL), and then the mixture was subjected to dehydration condensation at 120°C for 24 hours. The solvent was evaporated under reduced pressure in an evaporator. The resultant product was purified by silica gel flash column chromatography (hexane/ethyl acetate = 10/1, 5/1), thus obtaining bromoacetic acid benzyl ester (34.3 g, 150 mmol) quantitatively as a yellow oily product.
R_{f} 0.71 (hexane/ethyl acetate = 4/1);
¹H NMR (500 MHz, ppm, CDCl₃) δ 3.81 (s, 2H), 5.14 (s, 2H), 7.31 (s, 5H);
¹³C NMR (125 MHz, ppm, CDCl₃) δ 25.74, 67.79, 128.27, 128.48, 128.54, 134.88, 166.91;
IR (neat, cm⁻¹) 2959, 1751, 1458, 1412, 1377, 1167, 972, 750, 698.

[Second Step]: In an argon atmosphere, triethylamine (17 mL, 120 mmol) was added to a dichloromethane (90 mL) solution of the bromoacetic acid benzyl ester (13.7 g, 60 mmol) at 0°C, and the obtained mixture was stirred at 0°C for 20 minutes. Then a dichloromethane (40 mL) solution of 2-(2-aminoethoxy)ethanol (12 mL, 120 mmol) was added thereto, and the resultant mixture was stirred at room temperature for 4 hours. The organic layer was washed with water (three times) and then dried with anhydrous magnesium sulfate. The solvent was evaporated under reduced pressure in an evaporator. Subsequently, the resultant product was purified by silica gel flash column chromatography (developing solvent: ethyl acetate/methanol = 1/0, 10/1, 5/1), thus obtaining, as a colorless oily product, benzyl[2-(2-hydroxyethoxy)ethylamino]acetate 2 (12.2 g, 48.0 mmol) with a yield of 80%.
R_{f} 0.48(ethyl acetate/methanol = 2/1);
¹H NMR (500 MHz, ppm, CDCl₃) δ 2.83 (t, 2H, J = 5.1 Hz), 3.50 (s, 2H), 3.52 (t, 2H, J = 4.6 Hz), 3.58 (t, 2H, J = 5.0 Hz), 3.65 (t, 2H, J = 4.6 Hz), 5.11 (s, 2H), 7.28-7.30 (m, 5H);
¹³C NMR (125 MHz, ppm, CDCl₃) δ 48.46, 50.25, 61.29, 66.38, 69.80, 72.23, 126.63, 128.12, 128.37, 135.30, 171.78;
IR (neat, cm⁻¹) 3412, 2880, 1719, 1638, 1560, 1508, 1458, 1067, 669.

### (Synthesis of [2-(2-methoxyethoxy)ethylamino]acetic acid 1)

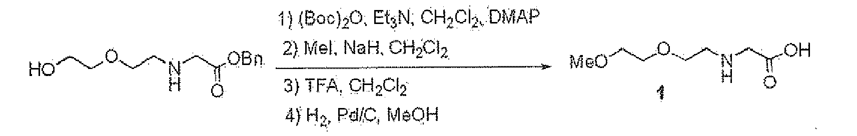

[First Step]: Triethylamine (4.3 mL, 31 mmol) was added to a dichloromethane (50 mL) solution of the benzyl[2-(2-hydroxyethoxy)ethylamino]acetate 2 (6.58 g, 26 mmol) at 0°C in an argon atmosphere, and 4-(N,N-dimethylamino)pyridine (DMAP) (32 mg, 0.26 mmol) was added to the mixture. The obtained mixture was stirred for 20 minutes, and a dichloromethane (10 mL) solution of di-tert-butyl dicarbonate (6.77 g, 31 mmol) was added dropwise thereto.

The reaction mixture was stirred at room temperature for 4 hours and poured into a conical flask containing water to terminate the reaction, and the resultant mixture was extracted with diethyl ether (three times). The organic layer was dried, concentrated under reduced pressure, and purified by silica gel flash column chromatography (developing solvent: hexane/ethyl acetate = 3/1, 2.5/1, 2/1), thus obtaining benzyl {tert-butoxycarbonyl-[2-(2-hydroxy-ethoxy)ethyl]amino}acetate (5.83 g, 16.5 mmol) as a colorless oily product with a yield of 63%.
R_{f} 0.58 (ethyl acetate/methanol = 20/1);
¹H NMR (500 MHz, ppm, CDCl₃) δ 1.34 (d, 9H, J = 54.5 Hz), 2.19 (brs, 1H), 3.38-3.45 (m, 4H), 3.50-3.60 (m, 4H), 3.99 (d, 2H, J = 41.3 Hz), 5.09 (d, 2H, J = 4.1 Hz), 7.25-7.30 (m, 5H);
¹³C NMR (125 MHz, ppm, CDCl₃) δ 27.82, 28.05, 47.90, 48.20, 49.81, 50.39, 61.23, 66.42, 69.92, 72.12, 80.08, 127.93, 128.14, 135.25, 154.99, 155.19, 169.94, 170.07;
IR (neat, cm⁻¹) 3449, 2934, 2872, 1751, 1701, 1458, 1400, 1367, 1252, 1143;
Anal. Calcd for C₁₈H₂₇NO₆: C, 61.17; H, 7.70; N, 3.96.
Found: C, 60.01; H, 7.75; N, 4.13.

[Second Step]: A tetrahydrofuran (THF) (20 mL) solution of the benzyl{tert-butoxycarbonyl-[2-(2-hydroxy-ethoxy)ethyl]amino}acetate (5.83 g, 16.5 mmol) was added dropwise to a THF (10 mL) solution of sodium hydride (1.2 g, 24.8 mmol, 50% in mineral oil) at 0°C in an argon atmosphere. The mixture was stirred at 0°C for 20 minutes, and then iodomethane (1.6 mL, 24.8 mmol) was added to the mixture at 0°C. The reaction mixture was stirred at room temperature for 20 hours, and then water was added thereto while the reaction mixture was cooled in an ice bath to terminate the reaction. The resultant mixture was extracted with ether (three times). The organic layer was dried, concentrated under reduced pressure, and purified by silica gel flash column chromatography (developing solvent: hexane/ethyl acetate = 5/1, 3/1), thus obtaining, as a colorless oily product, benzyl {tert-butoxycarbonyl-[2-(2-methoxy-ethoxy)ethyl]amino}acetate (3.02 g, 8.21 mmol) with a yield of 50%.
R_{f} 0.54(hexane/ethyl acetate = 1/1);
¹H NMR (500 MHz, ppm, CDCl₃) δ 1.34 (d, 9H, J = 51.8 Hz), 3.28 (d, 3H, J = 2.7 Hz), 3.37-3.46 (m, 6H), 3.52 (dt, 2H,
J = 5.4Hz, 16.5 Hz), 4.02 (d, 2H, J = 34.8 Hz), 5.09 (d, 2H, J = 4.5 Hz), 7.24-7.30 (m, 5H);
¹³C NMR (125 MHz, ppm, CDCl₃) δ 24.93, 25.16, 44.68, 45.00, 46.70, 47.40, 55.78, 63.30, 67.22, 68.60, 76.95, 124.98, 125.14, 125.36, 132.49, 151.99, 152.31, 166.84, 166.96;
IR (neat, cm⁻¹) 2880, 1751, 1701, 1560, 1458, 1400, 1366, 1117, 698, 617;
Anal. Calcd for C₁₉H₂₉NO₆: C, 62.11; H, 7.96; N, 3.81.
Found: C, 62.15; H, 8.16; N, 3.83.

[Third Step]: Trifluoroacetic acid (TFA) (9.0 mL) was added to a dichloromethane (17 mL) solution of the benzyl{tert-butoxycarbonyl-[2-(2-methoxy-ethoxy)ethyl]amino)acetate (3.02 g, 8.21 mmol) in an argon atmosphere, and the mixture was stirred at room temperature for 7 hours. Then a 10% aqueous solution of sodium carbonate was added to the mixture to adjust the pH thereof to 10, and the resultant mixture was extracted with dichloromethane. The organic layer was dried with anhydrous magnesium sulfate and concentrated under reduced pressure, thus obtaining benzyl[2-(2-methoxy-ethoxy)ethylamino]acetate (2.18 g, 8.19 mmol) quantitatively as a yellow oily product.
R_{f} 0.32 (ethyl acetate/methanol = 20/1);
¹H NMR (500 MHz, ppm, CDCl₃) δ 1.99 (brs, 1H), 2.83 (t, 2H, J = 5.3 Hz), 3.38 (s, 3H), 3.50 (s, 2H), 3.54 (t, 2H, J = 4.6 Hz), 3.60-3.62 (m, 4H), 5.17 (s, 2H), 7.32-7.38 (m, 5H);
¹³C NMR (125 MHz, ppm, CDCl₃) δ 48.46, 50.66, 58.76, 66.20, 70.00, 70.44, 71.64, 128.09, 128.33, 135.44, 171.84;
IR (neat, cm⁻¹) 3350, 2876, 1736, 1560, 1458, 1117, 1030, 698, 619;
Anal. Calcd for C₁₄H₂₁NO₄: C, 62.90; H, 7.92; N, 5.24.
Found: C, 62.28; H, 8.20; N, 5.05.

[Fourth Step]: Activated carbon (219 mg) supporting 10% by weight of palladium was added to a methanol (27 mL) solution of the benzyl[2-(2-methoxy-ethoxy)ethylamino]acetate (2.19 g, 8.19 mmol) at room temperature. Hydrogen gas was purged, and then the mixture was stirred in a hydrogen atmosphere at room temperature for 7 hours. The Pd/C was removed with a glass filter covered with a Celite pad, and the Celite layer was washed with methanol. The filtrate was concentrated under reduced pressure, thus obtaining, as a yellow oily product, [2-(2-methoxyethoxy)ethylamino]acetic acid 1 (1.38 g, 7.78 mmol) with a yield of 95%.
¹H NMR (500 MHz, ppm, MeOD) δ 3.21 (t, 2H, J = 5.1 Hz), 3.38 (s, 3H), 3.51 (s, 2H), 3.57 (t, 2H, J = 4.4 Hz), 3.65 (t, 2H, J = 4.6 Hz), 3.73 (t, 2H, J = 5.1 Hz);
¹³C NMR (125 MHz, ppm, MeOD) δ 48.13, 50.49, 59.16, 67.08, 71.05, 72.85, 171.10;
IR (neat, cm⁻¹) 3414, 2827, 1751, 1630, 1369, 1111, 1028, 851, 799;
Anal. Calcd for C₇H₁₅NO₄: C, 47.45; H, 8.53; N, 7.90. Found: C, 46.20; H, 8.49; N, 7.43.

### Synthesis of aldehyde 4

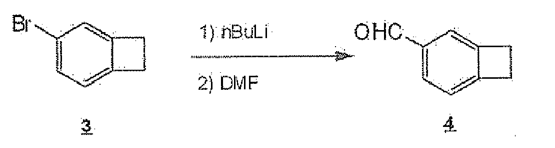

Into a 50 mL recovery flask, a bromo compound 3 (3.0 g (16.3 mmol)) represented by the formula 3 above and 50 mL of anhydrous tetrahydrofuran (THF) were charged in a nitrogen atmosphere. The mixture was cooled to -78°C under nitrogen flow. Then, 11.3 mL (18.0 mmol) of a hexane solution (1.59 M) of n-butyl lithium was added dropwise to the mixture, and the resultant mixture was stirred at -78°C for 30 minutes. Subsequently, 2.40g of anhydrous dimethylformamide was added dropwise to the recovery flask, and the mixture was further stirred at -78°C for 30 minutes. The temperature of the mixture was raised to room temperature, and the mixture was further stirred for 1 hour. The reaction liquid was poured into 100 mL of water, and the oil phase was extracted twice with 50 mL of ethyl acetate and then dried with anhydrous magnesium sulfate. The magnesium compound was removed by filtration, and the resultant oil phase was concentrated under reduced pressure in an evaporator. The obtained residue was purified by silica gel chromatography (WakosilC-300, developing liquid: hexane/ethyl acetate = 3:1 (volume ratio)), thus obtaining 1.54 g of the target compound aldehyde 4 represented by the above formula 4 (yield: 71.1%).
¹H-NMR (270 MHz / CDCl₃) :
δ 3.24 (s, 4H), 7.21 (d, 1H), 7.57 (s, 1H), 7.72 (d, 1H), 9.93 (s, 1H)

### <Synthesis Example 3>

Synthesis of fullerene derivative H before polymerization and fullerene derivative I before polymerization

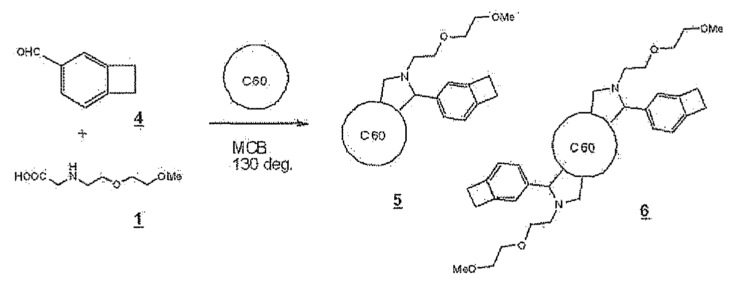

Into a 50 mL recovery flask, the aldehyde 4 {0.19 g (1.40 mmol)} represented by the formula 4 above, the [2-(2-methoxyethoxy)ethylamino]acetic acid 1 {0.19 g (1.04 mmol)} represented by the formula 1 above, 0.50 g (0.69 mmol) of C60, and 30 mL of chlorobenzene were charged in a nitrogen atmosphere, and the mixture was stirred at 130°C for 6 hours under nitrogen flow. After cooled to room temperature, the reaction mixture was concentrated under reduced pressure in an evaporator. Then, fullerene derivatives before polymerization were separated from the obtained residue by silica gel chromatography (WakosilC-300). When the fullerene derivatives before polymerization were separated, carbon disulfide (CS₂) was used as the developing liquid for the silica gel chromatography to separate and collect unreacted C60. Subsequently, the developing liquid was changed to a solvent mixture of toluene and ethyl acetate, and the ratio in the solvent mixture was set to from 100:0 (the volume ratio of toluene to ethyl acetate) to 90:10 (the volume ratio of toluene to ethyl acetate) to separate crystals containing a fullerene derivative before polymerization. The obtained crystals were washed with 10 mL of methanol and dried under reduced pressure, thus obtaining 80 mg of the target product fullerene derivative H before polymerization, represented by the formula 5 above (yield: 11.9%).

Next, the ratio of toluene/ethyl acetate in the solvent mixture used as the developing liquid was changed to 1:1 (volume ratio) to perform fractionation. The fractionated solution was concentrated, and the residue was washed with 10 mL of methanol and dried under reduced pressure, thus obtaining a total of 116 mg of a fullerene derivative before polymerization having at least two structures represented by the formula (12). Examples of the fullerene derivative before polymerization having at least two structures represented by the formula (12) include a fullerene derivative I before polymerization represented by the formula 6 above.

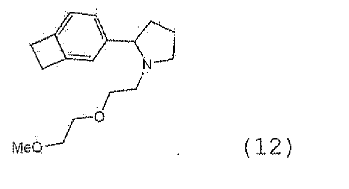

The results of NMR analysis for the fullerene derivative H before polymerization are shown below.
¹H-NMR (270 MHz / CDCl₃):
δ 2.82 (m, 1H), 3.16 (brs, 4H), 3.30-3.50 (m, 1H), 3.45 (s, 3H) 3.65 (m, 2H), 3.72-3.80 (m, 2H), 3.90-4.10 (m, 2H), 4.28 (d, 1H), 5.10 (s, 1H), 5.20 (d, 1H), 7.06 (d, 1H). 7.40-7.70 (brd, 1H).

### <Synthesis of macromolecular compound 3>

A 200 mL separable flask was charged with 1.061 g (2.00 mmol) of 9,9-dioctylfluorene-2,7-diboric acid ethylene glycol ester, 0.987 g (1.80 mmol) of 9,9-dioctyl-2,7-dibromofluorene, 0.174 g (0.20 mmol) of N,N'-bis(2,6-diisopropylphenyl) -dibromoperylene-3,4,9,10-tetracarboxylic diimide (an isomer mixture of a 1,6-dibromo compound and a 1,7-dibromo compound), 0.26 g of methyltrioctylammonium chloride (product name: Aliquat336, a product of Aldrich), and 20 mL of toluene.

In a nitrogen atmosphere, 2.1 mg of bistriphenylphosphine palladium dichloride was added to the solution, and the resultant solution was heated to 85°C. The solution was heated to 105°C while 5.4 mL of a 17.5% by weight of an aqueous solution of sodium carbonate was added dropwise thereto, and then the solution was stirred for 6 hours. Next, 0.244 g of phenylboronic acid and 20 mL of toluene were added to the solution, and the resultant solution was stirred at 105°C overnight.

After the aqueous layer was removed, 1.11 g of sodium N,N-diethyldithiocarbamate trihydrate and 22 mL of ion exchanged water was added thereto, and the resultant mixture was stirred at 85°C for 2 hours. After the organic layer and the aqueous layer were separated from each other, the organic layer was washed with ion exchanged water (twice), a 3% by weight of an aqueous solution of acetic acid (twice), and ion exchanged water (twice) in this order.

The organic layer was added dropwise to methanol to precipitate a polymer, and the precipitated product was filtrated and dried to obtain a solid.

The solid was dissolved in toluene, and the solution was applied to a silica gel/alumina column to which toluene had been applied, and the resultant eluate was added dropwise to methanol to precipitate a polymer. The precipitated product was filtrated and dried, thus obtaining 1.14 g of a macromolecular compound (hereinafter referred to as a macromolecular compound 3). The number average molecular weight and weight average molecular weight thereof in terms of polystyrene were Mn = 1.2 × 10⁴ and Mw = 2.6 × 10⁴.

The macromolecular compound 3 is a polymer having the following repeating units in a molar ratio shown below (95:5) (a theoretical value determined from the raw materials).

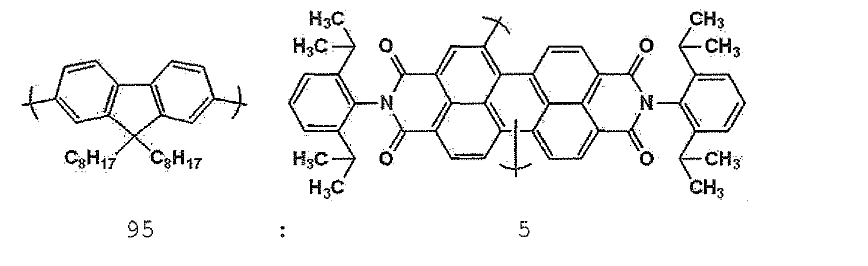

The N,N'-bis(2,6-diisopropylphenyl)-dibromoperylene-3,4,9,10-tetracarboxylic diimide (an isomer mixture of a 1,6-dibromo compound and a 1,7-dibromo compound) can be synthesized, for example, by a method described in Journal of Chemistry, Vol.70 (2005) pp. 4323-4331.

### <Preparation of applying solution A>

The macromolecular compound 1 was dissolved in xylene at a concentration of 1.0% by weight, and the solution was filtrated through a Teflon (registered trademark) filter having a pore size of 0.2 µm, thus preparing an applying solution A.

### <Preparation of applying solution B>

The macromolecular compound 2 was dissolved in xylene at a concentration of 0.5% by weight, and [6,6]-phenyl C61-butyric acid methyl ester (PCBM) (ADS61BFB, product of American Dye Source, Inc.) as a fullerene derivative was dissolved in the solution {macromolecular compound 2 : PCBM = 9:1 (weight ratio)}. The resultant solution was filtrated through a Teflon (registered trademark) filter having a pore size of 0.2 µm, thus preparing an applying solution B.

### <Preparation of applying solution C>

The macromolecular compound 2 was dissolved in xylene at a concentration of 0.5% by weight, and [6,6]-phenyl C61-butyric acid methyl ester (PCBM) (ADS61BFB, product of American Dye Source, Inc.) as the fullerene derivative was dissolved in the solution {macromolecular compound 2 : PCBM = 95:5 (weight ratio)}. The resultant solution was filtrated through a Teflon (registered trademark) filter having a pore size of 0.2 µm, thus preparing an applying solution C.

### <Preparation of applying solution D>

The macromolecular compound 2 was dissolved in xylene at a concentration of 0.5% by weight, and [6,6]-phenyl C61-butyric acid methyl ester (PCBM) (ADS61BFB, product of American Dye Source, Inc.) as the fullerene derivative was dissolved in the solution {macromolecular compound 2 : PCBM = 99:1 (weight ratio)}. The resultant solution was filtrated through a Teflon (registered trademark) filter having a pore size of 0.2 µm, thus preparing an applying solution D.

### <Preparation of applying solution E>

The macromolecular compound 2 was dissolved in xylene at a concentration of 0.5% by weight, and the solution was filtrated through a Teflon (registered trademark) filter having a pore size of 0.2 µm, thus preparing an applying solution E.

### <Preparation of applying solution F>

The macromolecular compound 2 was dissolved in xylene at a concentration of 0.5% by weight, and the fullerene derivative H before polymerization was dissolved in the solution {macromolecular compound 2 : fullerene derivative H before polymerization = 95:5 (weight ratio)}. The resultant solution was filtrated through a Teflon (registered trademark) filter having a pore size of 0.2 µm, thus preparing an applying solution F.

### <Preparation of applying solution G>

The macromolecular compound 2 was dissolved in xylene at a concentration of 0.5% by weight, and as the fullerene derivative before polymerization, the fullerene derivative I before polymerization, which was produced in Synthesis Example 3, having at least two structures represented by the formula (12) was dissolved in the solution {macromolecular compound 2 : fullerene derivative I before polymerization = 95:5 (weight ratio)}. The resultant solution was filtrated through a Teflon (registered trademark) filter having a pore size of 0.2 µm, thus preparing an applying solution G.

### <Preparation of applying solution H>

The macromolecular compound 2 was dissolved in chlorobenzene at a concentration of 0.5% by weight, and the following compound (purchased from Sigma-Aldrich) was dissolved in the solution {macromolecular compound 2 : compound = 95:5 (weight ratio)}, thus preparing an applying solution H. 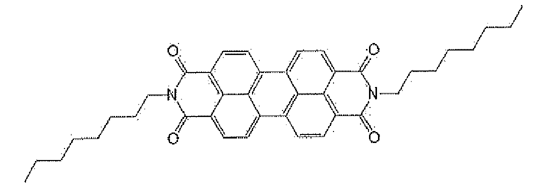 N,N'-Dioctyl-3,4,9,10-perylenedicarboximide

### <Preparation of applying solution I>

The macromolecular compound 2 was dissolved in xylene at a concentration of 0.5% by weight, and the following compound (purchased from Sigma-Aldrich) was dissolved in the solution {macromolecular compound 2 : the following compound = 95:5 (weight ratio)}, thus preparing an applying solution I. 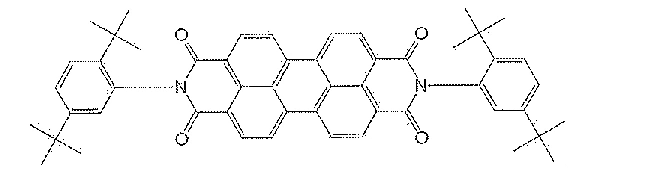 N,N'-Bis(2,5-di-tert-butylphenyl)-3,4,9,10-perylenedicarboximide

### <Preparation of applying solution J>

The macromolecular compound 2 was dissolved in xylene at a concentration of 0.5% by weight, and [6,6]-phenyl C61-butyric acid methyl ester (PCBM) (ADS61BFB, product of American Dye Source, Inc.) as a fullerene derivative was dissolved in the solution {macromolecular compound 2 : PCBM = 100:20 (weight ratio)}. The resultant solution was filtrated through a Teflon (registered trademark) filter having a pore size of 0.2 µm, thus preparing an applying solution J.

### <Preparation of Coating Solution K>

The macromolecular compound 2 was dissolved in xylene at a concentration of 0.5% by weight, and the macromolecular compound 3 was dissolved in chlorobenzene at a concentration of 1% by weight. These solutions were mixed in a ratio of macromolecular compound 2 : macromolecular compound 3 = 80:20 (weight ratio), and the resultant solution was filtrated through a Teflon (registered trademark) filter having a pore size of 0.2 µm, thus preparing an applying solution K.

### <Example 1>

### (Preparation and evaluation of organic EL element)

On a glass substrate having, as an anode, an ITO film (film thickness: 150 nm) formed thereon by sputtering, a solution for forming a hole injection layer (product name: HIL764, a product of Plextronics) was spin-coated. The resultant substrate was dried on a hot plate at 170°C for 15 minutes in air, thus forming a hole injection layer (thickness: 50 nm). Then, the applying solution B was spin-coated on the hole injection layer, and the resultant substrate was baked in a glove box at 180°C for 60 minutes in a nitrogen atmosphere, thus forming a hole transport layer (thickness: 20 nm). Then, the applying solution A was spin-coated on the hole transport layer, thus forming a light-emitting layer. The light-emitting layer was formed such that the layer had a thickness of 80 nm.

Subsequently, the resultant substrate was baked on a hot plate at 130°C for 10 minutes in a nitrogen atmosphere. Then, NaF was vapor deposited thereonto in a thickness of 4 nm, and Al was vapor deposited thereonto in a thickness of 100 nm, thus forming a cathode.

The degree of vacuum during vapor deposition was in the range of 1 × 10⁻⁴ Pa to 9 × 10⁻³ Pa. The obtained element had a shape of 2 mm × 2 mm regular tetragon. The obtained element was driven at a constant current and an initial brightness of 5,000 cd/m² to perform a life test. The time until the brightness was reduced to 4,000 cd/m² (80% of the initial brightness) was measured (this time is referred to as LT80). The measurement results are shown in Table 1.

### <Example 2>

### (Preparation and evaluation of organic EL element)

An organic EL element was prepared by the same method as in Example 1, except that the applying solution C was used instead of the applying solution B. Further, the LT80 of the organic EL element was measured by the same method as in Example 1. The measurement results are shown in Table 1.

### <Example 3>

### (Preparation and evaluation of organic EL element)

An organic EL element was prepared by the same method as in Example 1, except that the applying solution D was used instead of the applying solution B. Further, the LT80 of the organic EL element was measured by the same method as in Example 1. The measurement results are shown in Table 1.

### <Example 4>

### (Preparation and evaluation of organic EL element)

An organic EL element was prepared by the same method as in Example 1, except that the applying solution F was used instead of the applying solution B. Further, the LT80 of the organic EL element was measured by the same method as in Example 1. The measurement results are shown in Table 1.

### <Example 5>

### (Preparation and evaluation of organic EL element)

An organic EL element was prepared by the same method as in Example 1, except that the applying solution G was used instead of the applying solution B. Further, the LT80 of the organic EL element was measured by the same method as in Example 1. The measurement results are shown in Table 1.

### <Example 6>

### (Preparation and evaluation of organic EL element)

An organic EL element was prepared by the same method as in Example 1, except that the applying solution H was used instead of the applying solution B. Further, the LT80 of the organic EL element was measured by the same method as in Example 1. The measurement results are shown in Table 1.

### <Example 7>

### (Preparation and evaluation of organic EL element)

An organic EL element was prepared by the same method as in Example 1, except that the applying solution I was used instead of the applying solution B. Further, the LT80 of the organic EL element was measured by the same method as in Example 1. The measurement results are shown in Table 1.

### <Example 8>

### (Preparation and evaluation of organic EL element)

On a glass substrate having, as an anode, an ITO film (thickness: 150 nm) formed thereon by sputtering, a hole injection layer forming solution (product name: HIL764, product of Plextronics) was spin-coated. The resultant substrate was dried on a hot plate at 170°C for 15 minutes in air, thus forming a hole injection layer (thickness: 50 nm). Then, the applying solution B was spin-coated on the hole injection layer, and the resultant substrate was baked in a glove box at 180°C for 60 minutes in a nitrogen atmosphere, thus forming a hole transport layer 1 (thickness: 10 nm). Then, the applying solution E was spin-coated on the hole transport layer 1, and the resultant substrate was baked in a glove box at 180°C for 60 minutes in a nitrogen atmosphere, thus forming a hole transport layer 2 (thickness: 10 nm). Then, the applying solution A was spin-coated on the hole transport layer 2, thus forming a light-emitting layer. The light-emitting layer was formed such that the layer had a thickness of 80 nm.

### <Example 9>

### (Preparation and evaluation of organic EL element)

An organic EL element was prepared by the same method as in Example 1, except that the applying solution K was used instead of the applying solution B. Further, the LT80 of the organic EL element was measured by the same method as in Example 1. The measurement results are shown in Table 1.

Subsequently, the resultant substrate was baked on a hot plate at 130°C for 10 minutes in a nitrogen atmosphere. Then, NaF was vapor deposited thereonto in a thickness of 4 nm, and Al was vapor deposited thereonto in a thickness of 100 nm, thus forming a cathode.

The degree of vacuum during vapor deposition was in the range of 1 × 10⁻⁴ Pa to 9 × 10⁻³ Pa. The element had a shape of 2 mm × 2 mm regular tetragon. The obtained element was driven at a constant current and an initial brightness of 5,000 cd/m² to perform a life test. The time until the brightness was reduced to 4,000 cd/m² (80% of the initial brightness) was measured (this time is referred to as LT80). The measurement results are shown in Table 1.

### <Comparative Example 1>

### (Preparation and evaluation of organic EL element)

An organic EL element was prepared by the same method as in Example 1, except that the applying solution E was used instead of the applying solution B. Further, the LT80 of the organic EL element was measured by the same method as in Example 1. The measurement results are shown in Table 1.

**Table 1**

| | LT80 (hours) |
|---|---|
| Example 1 | 16 hours |
| Example 2 | 6 hours |
| Example 3 | 3 hours |
| Example 4 | 8 hours |
| Example 5 | 6 hours |
| Example 6 | 2 hours |
| Example 7 | 3 hours |
| Example 8 | 2 hours |
| Example 9 | 5 hours |
| Comparative Example 1 | 0.6 hours |

### <Reference Example 1>

### (Preparation and evaluation of hole transport layer thin film)

The applying solution J containing a fullerene derivative was spin-coated on a glass plate, and the resultant glass plate was baked at 180°C for 60 minutes, thus forming an organic thin film (thickness: 20 nm). The PL spectra from the hole transport layer thin film was measured using an organic EL test system manufactured by Tokyo System Kaihatsu Co., Ltd. that used a UV light-emitting diode to irradiate excitation light of a wavelength of 375 nm.

### <Reference Example 2>

### (Preparation and evaluation of hole transport layer thin film)

The applying solution E containing no fullerene derivative was spin-coated on a glass plate, and the resultant glass plate was baked at 180°C for 60 minutes, thus forming an organic thin film (thickness: 20 nm). The PL spectra from the hole transport layer thin film was measured using the organic EL test system manufactured by Tokyo System Kaihatsu Co., Ltd. that used a UV light-emitting diode for excitation light. The value of PL intensity of Reference Example 1 at 435 nm was 7 when the value of Reference Example 2 was set to 100.

### -Evaluation-

As can be seen from Table 1, the use of a hole transport layer comprising an n-type semiconductor in addition to a macromolecular compound comprising a repeating unit having an amine residue allowed the preparation of an organic EL element having a longer life LT80, with comparison to the use of a hole transport layer formed only of a macromolecular compound comprising a repeating unit having an amine residue. As can be seen from Reference Examples 1 and 2, the PL intensity of the hole transport layer comprising a fullerene derivative was significantly lower than that of the hole transport layer comprising no fullerene derivative, and therefore quenching was found to occur.

### Industrial Applicability

The organic EL element of the present invention has a long element life LT80. Therefore, the present invention is very useful industrially.

## Claims

1. An organic electroluminescent element comprising:
a pair of electrodes composed of an anode and a cathode;
a light-emitting layer provided between the electrodes; and
a functional layer provided between the light-emitting layer and the anode, wherein
the functional layer comprises an n-type semiconductor and a macromolecular compound comprising a repeating unit having an amine residue.

2. The organic electroluminescent element according to claim 1, wherein the n-type semiconductor is a fullerene and/or a fullerene derivative.

3. The organic electroluminescent element according to claim 1, wherein the n-type semiconductor is a tetracarboxylic diimide derivative of perylene or naphthalene, or a tetracarboxylic dianhydride derivative of perylene or naphthalene.

4. The organic electroluminescent element according to any one of claims 1 to 3, wherein the n-type semiconductor is a macromolecular compound.

5. The organic electroluminescent element according to any one of claims 1 to 4, wherein the functional layer is in contact with the light-emitting layer.

6. The organic electroluminescent element according to any one of claims 1 to 5, wherein the repeating unit having an amine residue is represented by the following formula (1) : 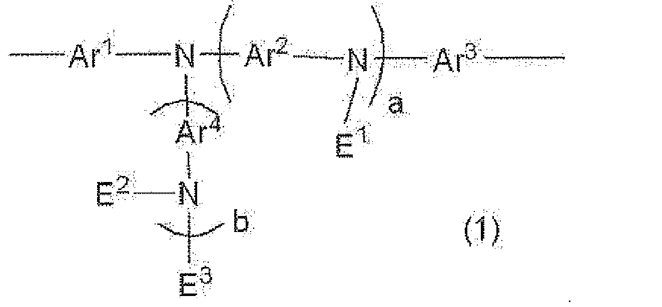 wherein
Ar¹, Ar², Ar³ and Ar⁴ each independently represent an arylene group or a divalent heterocyclic group; E¹, E² and E³ each independently represent an aryl group or a monovalent heterocyclic group; and a and b each independently represent 0 or 1, and
a group selected from among the groups represented by Ar¹. Ar³, Ar⁴, E¹ and E² may be bonded, directly or via -O-, -S-, -C(=O)-, -C(=O)-O-, -N (R⁷)-, -C (=O)-N (R⁷) -, or - C (R⁷) (R⁷)-, to a group selected from among the groups represented by Ar¹, Ar², Ar³, Ar⁴, E¹, E² and E³ which is bonded to the same nitrogen atom to which the former group selected is bonded, thereby forming a 5- to 7-membered ring, wherein R⁷ represents a hydrogen atom, an alkyl group, an aryl group, or a monovalent aromatic heterocyclic group; the group represented by R⁷ is optionally substituted with an alkyl group, an alkoxy group, an alkylthio group, a substituted carbonyl group, a substituted carboxyl group, an aryl group, an aryloxy group, an arylthio group, an aralkyl group, a monovalent aromatic heterocyclic group, a fluorine atom, or a cyano group; and a plurality of R⁷ may be the same as or different from each other.

7. The organic electroluminescent element according to any one of claims 1 to 6, wherein the macromolecular compound further comprises, in addition to the repeating unit represented by the formula (1), one or more types of repeating units selected from the group consisting of repeating units represented by the following formula (2), (3), (4) or (5) :
-Ar¹²⁻ (2)
-Ar¹²-X¹-(Ar¹³-X²)_{c}-Ar¹⁴- (3)
-Ar¹²-X²- (4)
-X²- (5)
wherein Ar¹², Ar¹³ and Ar¹⁴ each independently represent an arylene group, a divalent heterocyclic group, or a divalent group having a metal complex structure; X¹ represents - CR²=CR³-, -C≡C-, or -(SiR^{s}R⁶)_{d}-; X² represents -CR²=CR³-, - C=C-, -N(R⁴)-, or -(SiR⁵R⁶)_{d}-; R² and R³ each independently represent a hydrogen atom, an alkyl group, an aryl group, a monovalent heterocyclic group, a carboxyl group, a substituted carboxyl group, or a cyano group; R⁴, R⁵ and R⁶ each independently represent a hydrogen atom, an alkyl group, an aryl group, a monovalent heterocyclic group, or an arylalkyl group; c represents an integer from 0 to 2; d represents an integer from 1 to 12; and when Ar¹³, R², R³, R⁵ and R⁶ are each plurally present, they may be the same as or different from each other.

8. The organic electroluminescent element according to any one of claims 1 to 7, wherein the macromolecular compound is a macromolecular compound in which a macromolecular compound comprising a repeating unit that has an amine residue and comprises a polymerizable substituent is polymerized.

9. The organic electroluminescent element according to any one of claims 2 to 8, wherein the fullerene derivative is a macromolecular compound in which a fullerene derivative comprising a polymerizable substituent is polymerized.

10. A light-emitting device comprising the organic electroluminescent element of any one of claims 1 to 9.

11. A display device comprising the organic electroluminescent element of any one of claims 1 to 9.
